# EUROPEAN PATENT APPLICATION

(11) **EP 1 742 273 A1**
(43) Date of publication of application: **10.01.2007**
(21) Application number: 05728581.9
(22) Date of filing: 11.04.2005
(51) Int. Cl.: H01L 29/78, C23C 16/42, H01L 21/316, H01L 21/336

(54) **METHOD OF FORMING GATE INSULATING FILM, STORAGE MEDIUM AND COMPUTER PROGRAM**

(30) Priority: 09.04.2004 JP 2004115961
(71) Applicant: TOKYO ELECTRON LIMITED, Minato-ku, Tokyo 107-8481 (JP)
(72) Inventor: TAKAHASHI, Tsuyoshi, c/o Tokyo Electron AT Limited, Nirasaki-shi, Yamanashi 4070192 (JP); SHIMOMURA, Kouji, c/o Tokyo Electron AT Limited, Nirasaki-shi, Yamanashi 4070192 (JP); NAKAMURA, Genji, c/o Tokyo Electron Limited, Nirasaki-shi, Yamanashi 4070192 (JP); AOYAMA, Shintaro, c/o Tokyo Electron AT Limited, Nirasaki-shi, Yamanashi 4070192 (JP); YAMAZAKI, Kazuyoshi, c/o Tokyo Electron AT Limited, Nirasaki-shi, Yamanashi 4070192 (JP)
(74) Representative: Liesegang, Eva
(86) International application number: PCT/JP2005/007043
(87) International publication number: WO 2005/098961

(57) **Abstract**

A method of forming a gate insulation film 4 comprising a hafnium silicate material with a SiO₂ equivalent oxide thickness of 1.45 nm or less on a silicon substrate 1 is disclosed. The method includes the steps of: cleaning a surface of the silicon substrate 1 to establish thereon a clean surface on which substantially no oxygen is present;; forming a hafnium silicate film 2 on the clean surface of the silicon substrate 1 by a CVD process using an amide type organic hafnium compound and a silicon-containing raw material; applying an oxidation treatment to the hafnium silicate film 2, and applying a nitriding treatment to the hafnium silicate film 2 after applying the oxidation treatment. According to the method, a gate insulation film with favorable surface roughness can be obtained even if the film thickness is thin.

## Description

### TECHNICAL FIELD

The present invention relates to a method of forming a gate insulation film, and particularly to a method of forming a gate insulation film using a hafnium silicate (HfSiOₓ) series material. Further, the invention also relates to a computer-readable storage medium and a computer program for executing the method.

### BACKGROUND ART

Recently, the design rules for semiconductor devices constituting LSIs have been refined more and more in view of the demand for higher integration and higher operation speed of LSI. With this demand, a gate insulation film with an electric film thickness (SiO₂ Capacity Equivalent Oxide Thickness: EOT) of about 1.5 nm or less in a CMOS device has been requested. As a material for attaining such a thin insulation film without increasing a gate leakage current, high dielectric constant materials, so-called, high-k materials, have attracted a lot of attention.

Among these materials, hafnium silicate (HfSiOₓ) is highly heat resistant, has a high dielectric constant and can be formed by CVD, and thus has been studied as a candidate for gate insulation films in the next generation. In the case of forming such a thin insulation film by CVD, however, it is difficult to form a favorable interface with underlying silicon, and defects or impurities are generated in the film. Thus, the film quality is insufficient. Further, there is a possibility of causing phase separation of HfO₂ and SiO₂ and the stability of the film is insufficient.

In view of the above, it has been proposed a technique of cleaning the surface of a silicon wafer as an underlying material with a diluted hydrofluoric acid, forming directly thereon a hafnium silicate film formed by CVD, and applying plasma oxidation treatment and plasma nitriding treatment, thereby to attain control for the boundary between the silicon wafer and the hafnium silicate film and improve the film quality (Inumiya, et al. 2003 Symposium on VLSI Technology Digest of Technical Papers, June 10-12, 2003, hereinafter referred to as "Non-Patent Document 1" or simply as "Document 1"). In the Document 1, a hafnium silicate film is formed by using HTB (hafnium tetra tertiary butoxide) as a hafnium raw material, and by using TEOS (tetraethoxysilane) as a silicon raw material, by MO-CVD (organic metal CVD).

However, in the case of forming a hafnium silicate film with a further thin thickness by using the technique described above, roughness of the hafnium silicate film formed by CVD increases, resulting in the possibility that the insulation property is insufficient for use as a gate insulation film.

### DISCLOSURE OF THE INVENTION

The present invention has been made in view of the foregoing situation and it is an object of the present invention to provide a method of forming a gate insulation film comprising a hafnium silicate series material with favorable surface roughness irrespective of the thin film thickness. Further, the present invention intends to provide a computer-readable storage medium and a computer program for executing the method.

To solve the subject described above, the present invention provides, in a first aspect, a method of forming a gate insulation film having an SiO₂ equivalent oxide thickness of 1.45 nm or less on a silicon substrate, the method including the steps of: cleaning a surface of the silicon substrate to establish thereon a clean surface on which substantially no oxygen is present; forming a hafnium silicate film on the clean surface of the silicon substrate by a CVD process using an amide type organic hafnium compound and a silicon-containing raw material; applying an oxidation treatment to the hafnium silicate film; and applying a nitriding treatment to the hafnium silicate film after applying the oxidation treatment.

In the first aspect, an amide type organic silicon compound can be used as the silicon-containing raw material. Further, tetrakisdiethylaminohafnium can be used as the amide type organic hafnium compound and tetrakisdimethylaminosilane can be used preferably as the amide type organic silicon compound. Further, the oxidation treatment and the nitriding treatment can be conducted by using plasma. Further, the oxidation treatment and the nitriding treatment can be conducted continuously in a single plasma treatment apparatus. The oxidation treatment and the nitriding treatment are conducted preferably by using plasma formed by radiating microwaves from a slot antenna.

The present invention provides, in a second aspect, a method of forming a gate insulation film with an SiO₂ equivalent oxide thickness of 1.45 nm or less on a silicon substrate, the method including the steps of: cleaning a surface of the silicon substrate to establish thereon a clean surface on which substantially no oxygen is present; forming a base film comprising a silicon oxide or a silicon oxynitride on the clean surface of the silicon substrate; forming a hafnium silicate film on the base film by a CVD process using an alkoxide type organic hafnium compound and a silicon-containing raw material; and applying a nitriding treatment to the hafnium silicate film.

In the second aspect, an alkoxide type organic silicon compound can be used for the silicon-containing raw material. Further, hafnium tetratertiarybutoxide can be used as the alkoxide type organic hafnium compound and tetraethoxysilane can be used preferably as the alkoxide type organic silicon compound. Further, the thickness of the base film is preferably 0.4 nm or more. Further, the nitriding treatment is conducted preferably by using plasma. In this case, it is conducted preferably by using plasma formed by radiation of microwaves from a slot antenna. Further, prior to the nitriding treatment, oxidation treatment is preferably applied to the hafnium silicate film and the oxidation treatment in this case is conducted preferably by using plasma. Also the oxidation treatment is conducted preferably by using plasma formed by radiating microwaves from the slot antenna. Furthermore, in the case of conducting the nitriding treatment and the oxidation treatment by using the plasma, they are conducted preferably continuously in a single plasma treatment apparatus. Furthermore, the forming of the base film is conducted preferably by one or both of treatment with UV-ray excited radicals and treatment with remote plasma. Among them, the oxidation treatment with the UV-ray excited radicals or the oxidation treatment with the UV-ray excited radicals plus the nitriding treatment with the remote plasma are particularly preferred.

The present invention provides, in a third aspect, a method of forming a gate insulation film with an SiO₂ equivalent oxide thickness of 1.45 nm or less on a silicon substrate, the method including the steps of: cleaning a surface of the silicon substrate to establish thereon a clean surface on which substantially no oxygen is present; forming a hafnium silicate film on the clean surface of the silicon substrate by a CVD process using tetrakisdiethylaminohafnium and tetrakisdimethylaminosilane; applying an oxidation treatment to the hafnium silicate film by using plasma formed by radiating microwaves from a slot antenna; and applying a nitriding treatment to the hafnium silicate film, after applying the oxidation treatment, by using plasma formed by radiating microwaves from a slot antenna.

In the third aspect, the step of forming the hafnium silicate film is conducted preferably at a film forming temperature within the range from 500 to 650°C and, particularly conducted preferably within the range from 500 to 550°C. Further, the step of forming the hafnium silicate film preferably has a first step of forming a film with a relatively high temperature and with a relatively high Si concentration and a second step of forming a film with a relatively low temperature and with a relatively low Si concentration. Further, the step of forming the hafnium silicate film is conducted preferably at a film forming pressure of 600 Pa or less. Further, the step of forming the hafnium silicate film is conducted preferably at an oxygen partial pressure of 40 Pa or less. The step of forming the hafnium silicate film is conducted preferably at a flow rate ratio of tetrakisdiethylaminohafnium to tetrakisdimethylaminosilane being 1 or more to 1.

The present invention provides, in a fourth aspect, a method of forming a gate insulation film with an SiO₂ equivalent oxide thickness of 1.45 nm or less on a silicon substrate, said method comprising the steps of: cleaning a surface of the silicon substrate to establish thereon a clean surface on which substantially no oxygen is present; forming a base film comprising silicon oxide or silicon oxynitride on the clean surface of the silicon substrate; forming a hafnium silicate film on the base film by a CVD process using hafniumtetratertiarybutoxide and tetraethoxysilane; applying an oxidation treatment to the hafnium silicate film by using plasma formed by radiating microwaves from a slot antenna; and applying a nitriding treatment to the hafnium silicate film, after applying the oxidation treatment, by using plasma formed by radiating microwaves from a slot antenna.

In the fourth aspect, the forming of the base film is conducted preferably by one or both of the treatment with UV-ray excited radicals and the treatment with remote plasma. Among them, the oxidation treatment with the UV-ray excited radicals, or the oxidation treatment with the UV-ray excited radicals and the nitriding treatment with the remote plasma is particularly preferred.

In the first to fourth aspects of the invention, the step of cleaning the surface of the silicon substrate can be conducted preferably with a hydrofluoric acid series detergent. Further, the SiO₂ equivalent oxide thickness of the gate insulation film is, preferably, 1.4 nm or less and, more preferably, 1.2 nm or less.

The present invention provides, in a fifth aspect, a computer-readable storage medium that stores software for causing a computer to execute a control program, wherein the control program, upon execution, causes a processing system to perform the steps of: forming a hafnium silicate film on a surface of a silicon substrate, which has been cleaned so as to establish thereon a clean surface on which substantially no oxygen is present, by a CVD process using an amide type organic hafnium compound and a silicon-containing raw material; applying an oxidation treatment to the hafnium silicate film; and applying a nitriding treatment to the hafnium silicate film after applying the oxidation treatment, whereby a gate insulation film with a SiO₂ equivalent oxide thickness of 1.45 nm or less is formed on the substrate on the silicon substrate.

The present invention provides, in a sixth aspect, a computer program including software that operates on a computer, wherein the software, upon execution, causes a processing system to perform the steps of: forming a hafnium silicate film on a surface of a silicon substrate, which has been cleaned so as to establish thereon a clean surface on which substantially no oxygen is present, by a CVD process using an amide type organic hafnium compound and a silicon-containing raw material; applying an oxidation treatment to the hafnium silicate film; applying a nitriding treatment to the hafnium silicate film after applying the oxidation treatment, whereby a gate insulation film with a SiO₂ equivalent oxide thickness of 1.45 nm or less is formed on the substrate on the silicon substrate.

The present invention provides, in a seventh aspect, a computer-readable storage medium that stores software for causing a computer to execute a control program, wherein the control program, upon execution, causes a processing system to perform the steps of: forming a base film comprising a silicon oxide or silicon oxynitride on a surface of a silicon substrate, which has been cleaned so as to establish a clean surface on which substantially no oxygen is present; forming a hafnium silicate film on the base film by a CVD process using an alkoxide type organic hafnium compound and a silicon-containing raw material; and applying a nitriding treatment to the hafnium silicate film, whereby a gate insulation film with a SiO₂ equivalent oxide thickness of 1.45 nm or less is formed on the silicon su bstrate.

The present invention provides, in an eighth aspect, a computer program comprising software that operates on a computer, wherein the software, upon execution, causes a processing system to perform the steps of: forming a base film comprising silicon oxide or silicon oxynitride on a surface of a silicon substrate, which has been cleaned so as to establish thereon a clean surface on which substantially no oxygen is present, forming a hafnium silicate film on the base film by a CVD process using an alkoxide type organic hafnium compound and a silicon-containing raw material; and applying a nitriding treatment to the hafnium silicate film, whereby a gate insulation film with a SiO₂ equivalent oxide thickness of 1.45 nm or less is formed on the silicon substrate.

In the first and the third aspects of the present invention, after the surface of the silicon substrate is cleaned to establish thereon a clean surface on which substantially no oxygen is present, a hafnium silicate film is formed directly on the cleaned surface by MO-CVD. Then, the oxidation treatment and the nitriding treatment are applied to the hafnium silicate film for improving the quality to form the gate oxide film. The amide type organic hafnium compound, which is liable to be decomposed, is used as a hafnium raw material. Thus, the gate oxide film is easily adsorbed uniformly. Even when the film thickness is as thin as 1.45 nm or less in SiO₂ equivalent oxide thickness (EOT), the surface roughness of the gate insulation film can be made small, resulting in reduction in the leakage current.

In the second and the fourth aspects of the present invention, after the surface of the silicon substrate is cleaned to establish thereon a clean surface on which substantially no oxygen is present, a base film is formed thereon. The base film comprises a silicon oxide or silicon oxynitride. Then, a hafnium silicate film is formed by MO-CVD using an alkoxide type organic hafnium compound and a silicon-containing raw material. The nitriding treatment is applied to the hafnium silicate film for improving the quality to form a gate oxide film. In the case of forming a hafnium silicate film using an alkoxide type organic hafnium compound, even when the film thickness is as thin as 1.45 nm or less in SiO₂ equivalent oxide thickness (EOT), the surface roughness of the gate insulation film can be made small, resulting in reduction in the leakage current.

### BRIEF DESCRIPTION OF DRAWINGS

Fig. 1 is a process chart for explaining process steps for forming a gate insulation film according to a first embodiment of the present invention.
Fig. 2 is a plan view showing a processing system of practicing a method according to the first embodiment of the present invention.
Fig. 3 is a cross sectional view showing a film forming apparatus mounted in a multi-chamber apparatus of the processing system of Fig. 2.
Fig. 4 is a graph showing the relationship between a temperature upon film formation, and a normalized leakage current value Δlg* and an Si concentration of a hafnium silicate film in the hafnium silicate film forming step according to the first embodiment of the present invention.
Fig. 5 is a graph showing the relationship between a temperature upon film formation, and ΔEOT and a Si concentration of the hafnium silicate film in the hafnium silicate film forming step according to the first embodiment of the present invention.
Fig. 6 is a graph showing the relationship between EOT and a leakage current value in the case of changing a film forming pressure in the hafnium silicate film forming step according to the first embodiment of the present invention.
Fig. 7 is a graph showing the relationship between a film forming pressure and a normalized leakage current value Δlg* in the hafnium silicate film forming step according to the first embodiment of the present invention.
Fig. 8 is a graph showing the relationship between an oxygen partial pressure, and ΔEOT and a Si concentration of the hafnium silicate film in the hafnium silicate film forming step according to the first embodiment of the present invention.
Fig. 9 is a graph showing the relationship between the flow ratio of TDEAT to TDMAS, and ΔEOT and the Si concentration of the hafnium silicate film in the hafnium silicate film forming step according to the first embodiment of the present invention.
Fig. 10 is a cross sectional view showing a plasma treatment apparatus mounted to the processing system shown in Fig. 2.
Fig. 11 is a graph for explaining the effects of the first embodiment of the present invention.
Fig. 12 is a process chart for explaining process steps for forming a gate insulation film according to a second embodiment of the present invention.
Fig. 13 is a graph showing the relationship between a Si concentration and EOT of a hafnium silicate film according to the second embodiment of the present invention.
Fig. 14 is a graph showing the relationship between the thickness of a base film and the surface roughness of a hafnium silicate film, comparing the case of using HTB and TEOS with the case of using TDEAH and TDMAS for the raw material upon forming the hafnium silicate film.
Fig. 15 is a graph showing the relationship between EOT and a leakage current in the case of forming a hafnium silicate film by using an alkoxide series material (HTB and TEOS) of the second embodiment of the present invention without disposing an underlying layer and of conducting the post treatment with plasma.
Fig. 16 is a graph showing the relationship between EOT and a leakage current in the case of disposing a base film, forming a hafnium silicate film thereon by using the alkoxide series material (HTB and TEOS) according to the second embodiment of the invention and then applying a post treatment with plasma.
Fig. 17 is a graph showing the results of obtaining EOTs and leakage currents for each base film forming treatment and each post treatment after film formation in the second embodiment of the present invention.
Fig. 18 is a graph showing the results of obtaining EOTs in the case of changing the post treatment after the film formation, the film thickness (3 nm, 4 nm) and Si concentration (50%, 70%) after forming the base film of the hafnium silicate film under the same conditions in the second embodiment of the present invention.
Fig. 19 is a graph showing the results of obtaining EOTs in the case of changing the base film formation, post treatment after film formation, and the thickness of the hafnium silicate in the second embodiment of the present invention.
Fig. 20 is a graph for explaining the effect according to the second embodiment of the present invention.

### DESCRIPTION OF REFERENCE SIGNS

1,201...Silicon Wafer
2, 203...Hafnium Silicate Film
3, 204...Oxide Film
11, 12...Film Forming Apparatus
13, 14...Plasma Treatment Apparatus
100...Processing System
202...Base Film
300...Control Unit
301...User Interface
302...Memory Unit
W...Wafer

### BEST MODE FOR CARRYING OUT THE INVENTION

Embodiments of the present invention will be described with reference the accompanying drawings.

### [First Embodiment]

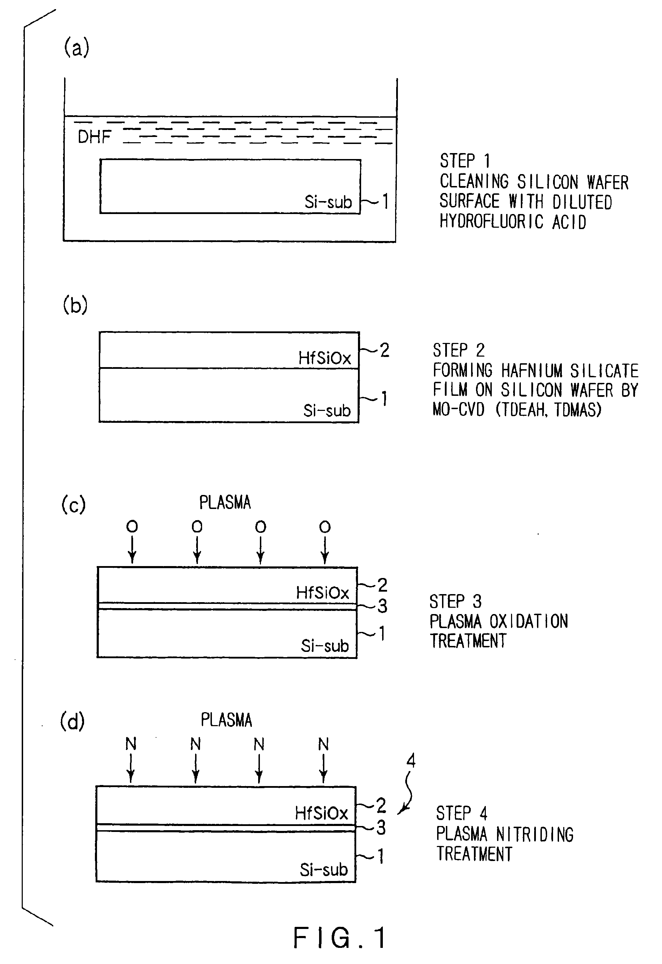

Fig. 1 is a process chart for explaining the method of forming a gate insulation film according to a first embodiment of the invention.

At first, in this embodiment, as shown in Fig. 1(a), a silicon wafer 1 is dipped, for example, in a diluted hydrofluoric acid (DHF) solution, thereby cleaning the surface of the silicon wafer 1 such that substantially no oxygen is present on the surface (step 1). As the diluted hydrofluoric acid, 1% hydrofluoric acid (HF content: 0.5 vol%) may be used and the treatment is applied, for example, at a room temperature for 1 to 3 minutes.

Then, as shown in Fig. 1(b), a hafnium silicate (HfSiOₓ) film 2 is formed by CVD(MO-CVD) using an organic metal material (step 2). In this case, a hafnium raw material, a silicon raw material, and an oxidizing agent are used as raw materials for the film formation. In the present embodiment, an amide type organic hafnium compound, for example, TDEAH (tetrakisdiethylaminohafnium) is used as the hafnium raw material, and an amide type organic silicon compound, for example, TDMAS (tetrakisdimethylaminosilane) is used as the hafnium raw material.

The molecular structures of TDEAH and TDMAS are as in the following formulas (1) and (2) below, respectively. The symbols Hf and Si at the center of the molecules are bonded with four N. In TDEAH, two ethyl groups are bonded to each N. In TDMAS, two methyl groups are bonded to each N.

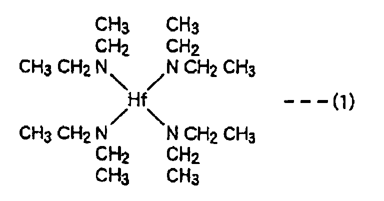

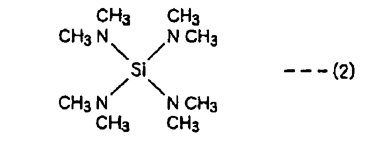

Then, as shown in Fig. 1(c), a plasma oxidation treatment is applied to the hafnium silicate film 2 formed as described above (step 3). The plasma oxidation treatment acts to bury oxygen defects in the hafnium silicate film 2, eliminate remaining impurities such as C, and form a thin oxide film 3 at the boundary between the silicon wafer 1 and the hafnium silicate (HfSiOₓ) film 2 to make the boundary morphology satisfactory. The plasma oxidation treatment preferably uses plasma with a low electron temperature and a high density since the hafnium silicate film 2 is not damaged by the treatment. For example, microwave plasma using a slot antenna, inductively coupled plasma (ICP), surface reflection wave plasma, and magnetron plasma may be used.

Successively, as shown in Fig. 1(d), a plasma nitriding treatment is applied to the hafnium silicate film 2 that has been subjected to the plasma oxidation treatment (step 4). The plasma nitriding treatment acts to prevent hafnium silicate from being phase-separated into HfO₂ and SiO₂, and further increase the dielectric constant by nitridation. Also, the plasma nitriding treatment preferably uses plasma with a low electron temperature and a high density since the hafnium silicate film 2 is not damaged by the treatment. Likewise, microwave plasma using the slot antenna, the inductively coupled plasma (ICP), the surface reflection wave plasma, the magnetron plasma, etc. may be used.

In this embodiment, a gate insulation film 4 with a thickness of 1.45 nm or less in EOT (Equivalent Oxide Thickness) is formed by the foregoing series of steps.

As described above, in this embodiment, an amide type organic hafnium compound, for example, TDEAH is used as the hafnium raw material and an amide type organic silicon compound, for example, TDMAS is used as the silicon raw material in the film formation of the hafnium silicate film 2. Since four N atoms are present around the metal atom at the center as shown in the above structural formula, they adsorb to the silicon wafer in the state where the metal atom and the N atoms are liable to be disconnected and the molecular structure is small. Accordingly, in the case of directly forming the film on the cleaned surface of the DHF of the silicon wafer, the film is liable to adsorb uniformly and the surface roughness of the gate insulation film can be made less than 0.3 nm in terms of the center line roughness Ra, and the leakage current can be decreased even when the film thickness is as thin as 1.45 nm or less in EOT.

For example, in the case of forming a hafnium silicate film directly on a silicon wafer subjected to a diluted hydrofluoric acid treatment by using an existent HTB-TEOS series raw material, if the film thickness is 1.45 nm or less in EOT, even when the plasma oxidation treatment and the plasma nitriding treatment are conducted subsequently in the same manner, the surface roughness of the gate insulation film is about 0.35 nm in terms of the center line roughness Ra and the surface roughness is not improved. On the contrary, in the case of forming a film on a substrate by using the TDEAH-TDMAS series raw material of the present embodiment, even when the film thickness of the gate insulation film is 1.45 nm or less in EOT, the surface roughness of the gate insulation film can be made as small as 0.2 to 0.25 nm in terms of the center line roughness Ra, and the leakage current can be decreased even when the thickness of the gate insulation film is reduced.

The thickness of the gate insulation film is, preferably, 1.4 nm or less and, more preferably, 1.2 nm or less. It is further preferably, 1.0 nm or less. As described above in this embodiment, even when the hafnium silicate film is thin, a film with small surface roughness can be formed and the leakage current can be in an allowable range.

In an actual device process, after forming the gate insulation film 4 as described above, a gate electrode material, for example, a film of polysilicon is formed on the hafnium silicate film 2, and doping of necessary impurities is conducted by ion implantation. Further, activation annealing is conducted and a gate electrode is formed by etching. Further, a diffusion region is formed on the main surface of the silicon wafer by ion implantation, to manufacture an MOS type transistor.

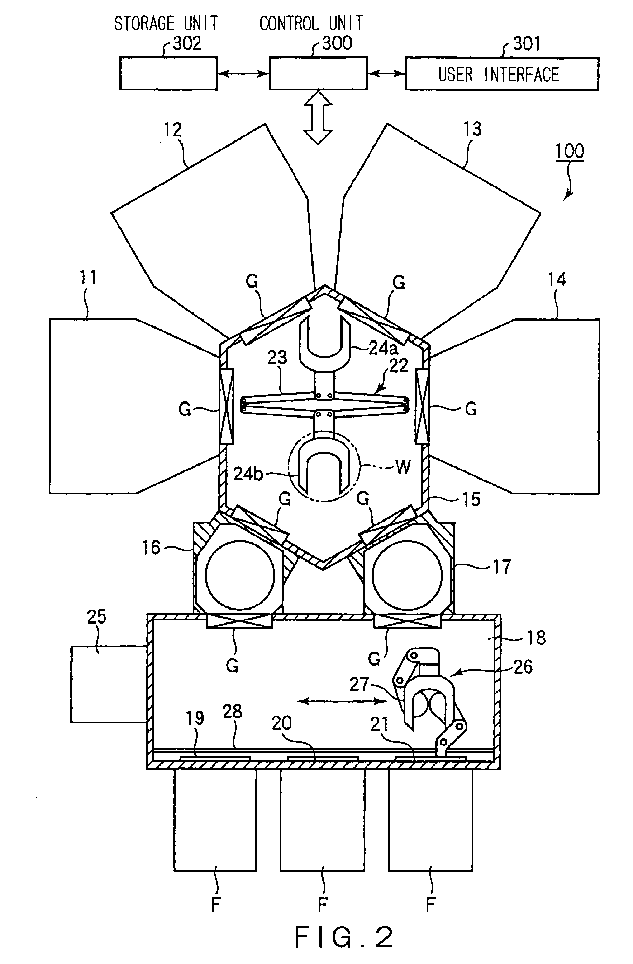

A description will be made of a system for practicing the method according to the present embodiment. Fig. 2 is a plan view showing an example of a processing system for practicing the method according to the present embodiment. A processing system 100 conducts treatments after the step 2 to the wafer that has been cleaned with the diluted hydrofluoric acid in the step 1.

As shown in Fig. 2, the processing system 100 has two film forming apparatuses 11, 12 for forming a hafnium silicate film by MO-CVD, and plasma treatment apparatuses 13, 14 for applying a plasma oxidation treatment and a plasma nitriding treatment to the hafnium silicate film. The film forming apparatuses 11, 12 and the plasma treatment apparatuses 13, 14 are provided corresponding to four sides of a hexagonal wafer transport chamber 15 respectively. Further, load lock chambers 16, 17 are provided to other two sides of the wafer transport chamber 15. A wafer loading-unloading chamber 18 is located to the side of the load lock chambers 16, 17 opposite to the wafer transport chamber 15. Ports 19, 20, 21 for attaching three FOUPs capable of containing wafers W are provided to the wafer loading-unloading chamber 18 on the side opposite to the load lock chambers 16, 17. The film forming apparatuses 11 and 12, and the plasma treatment apparatuses 13 and 14 have an identical structure with each other.

The film forming apparatuses 11, 12, the plasma treatment apparatuses 13, 14, and the load lock chambers 16, 17 are connected, as shown in the figure, to respective sides of the wafer transport chamber 15 each by way of a gate valve G and they are in communication with the wafer transport chamber 15 by opening each gate valve G and shut off from the wafer transport chamber 15 by closing each of the gate valves G. Further, gate valves G are also provided to portions of the load lock chamber 16, 17 connected with the wafer loading-unloading chamber 18 and the load lock chambers 16, 17 are in communication with the wafer loading-unloading chamber 18 by opening the gate valves G and shut off from the wafer loading-unloading chamber 18 by closing the same.

A wafer transport device 22 is provided in the wafer transport chamber 15 for loading or unloading wafer W, which is to be treated, to and from the film forming apparatuses 11, 12, plasma treatment apparatuses 13, 14, and the load lock chamber 16, 17. The wafer transport device 22 is located substantially at the center of the wafer transport chamber 15. The wafer transport device 22 has two blades 24a, 24b for holding the wafer W at the top end of a rotation/retraction portion 23 capable of rotation and stretching/contracting. The two blades 24a, 24b are attached to the rotation/retraction portion 23 so as to oppose to each other. The inside of the wafer transport chamber 15 is maintained at a predetermined vacuum degree.

An HEPA filter (not illustrated) is provided to the ceiling portion of the wafer loading-unloading chamber 18, a down flow of clean air, in which organic materials, particles, etc. have been removed through the HEPA filter, is supplied to the inside of the wafer loading-unloading chamber 18 such that the wafer W is loaded or unloaded in a clean air atmosphere at an atmospheric pressure. A shutter (not illustrated) is provided to each of the three ports 19, 20, 21 for attaching the FOUPs F of the wafer loading/unloading chamber 18. The FOUPs containing or not containing the wafers W are attached directly to the port 19, 20, 21. When the FOUPs are attached, the shutters are opened. The FOUPs are thus in communication, upon attachment, with the wafer loading-unloading chamber 18 while preventing intrusion of external air. An alignment chamber 25 is provided on a lateral side of the wafer loading-unloading chamber 18 where alignment for the wafer W is conducted.

A wafer transport device 26 is disposed in the wafer loading-unloading chamber 18 for loading and unloading the wafer W to and from the FOUP F and loading and unloading wafer to and from the load lock chamber 16, 17. The wafer transport chamber 26 has two multi-articulated arms. Further, the wafer transport chamber 26 can move on a rail 28 in the direction of the arrangement the FOUPs F and transports the wafer W while placing the same on a hand 27 at the top end thereof. Fig. 2 shows the state where one hand 27 is present in the wafer loading-unloading chamber 18, while the other hand is inserted in the FOUP F.

The component portions of the processing system 100, for example, film forming apparatuses 11, 12, plasma treatment apparatuses 13, 14, wafer transport devices 22, 26, etc. are adapted to be connected with and controlled by a control unit 300 comprising a computer. Further, the control unit 300 is connected with a user interface 301 comprising, for example, a key board for conducting operations for inputting commands, etc. in order to control the system by a process administrator, a display for visualizing the operation status of the system, and the like. Further, the control unit 300 is connected with a data storage unit 302. The storage unit 302 stores a control program for instructing the system to conduct various kinds of treatments by the control of the control unit 300 and a program, that is, a recipe for causing each of the component portions to conduct a treatment in accordance with the treatment conditions. The recipe may be stored in a hard disk or a semiconductor memory, or may be included in a portable storage medium such as CD-ROM, DVD, etc. to set to a predetermined position of the storage unit 302. Further, the recipe may be transmitted from other devices, for example, through an exclusive line. Then, a desired treatment is conducted in the processing system under the control of the control unit 300 by calling an arbitrary recipe from the storage unit 302 by the instruction from the user interface 301 and causing the control unit 300 to execute the called recipe as required. The control unit 300 may be adapted to directly control each of the component portions, or individual controllers may be provided to the component portions to control the component portions therethrough.

In such a processing system 100, at first, a FOUP F containing a wafer that has been subjected to a diluted hydrofluoric acid cleaning treatment and a drying treatment by a diluted hydrofluoric acid cleaning device (not-illustrated) is loaded.

Then, a wafer W formed with the cleaned surface by applying the diluted hydrofluoric acid treatment in the first step 1 is taken out of the FOUP F by the wafer transport device 26 in the wafer loading-unloading chamber 18 maintained in a clean air atmosphere at an atmospheric pressure and it is loaded to the alignment chamber 25 for positioning the wafer W. Successively, the wafer W is loaded to the load lock chamber 16 or 17. After evacuating the inside of the load lock, the wafer in the load lock is taken out by the wafer transport device 22 in the wafer transport chamber 15. The wafer W is entered into the film forming apparatus 11 or 12, and formation of the hafnium silicate film in the step 2 is conducted. In this case, the surface of the wafer W is maintained in a clean state while carrying the wafer W from the FOUP F to the film forming apparatus. The wafer W is entered into the film forming apparatus 11 or 12 in the cleaned state as it is. The wafer W with the hafnium silicate film formed is successively entered into the plasma treatment apparatus 13 or 14, and the plasma oxidation treatment in the step 3 and the plasma nitriding treatment in the step 4 are conducted. Then, after film formation, the wafer W is transported by the wafer transport device 22 to the load lock chamber 16 or 17. After restoring the inside of the load lock chamber to the atmospheric pressure, the wafer W in the load lock chamber is taken out by the wafer transport device 26 in the wafer loading-unloading chamber 18, and accommodated in one of the FOUPs F. The operation is conducted to the wafers W of one lot to complete the treatment for 1 set. With the treatment, the gate insulation film 4 described above is formed.

Then, the film forming apparatus 11 used for forming the hafnium silicate film 2 in the step 2 will be described.

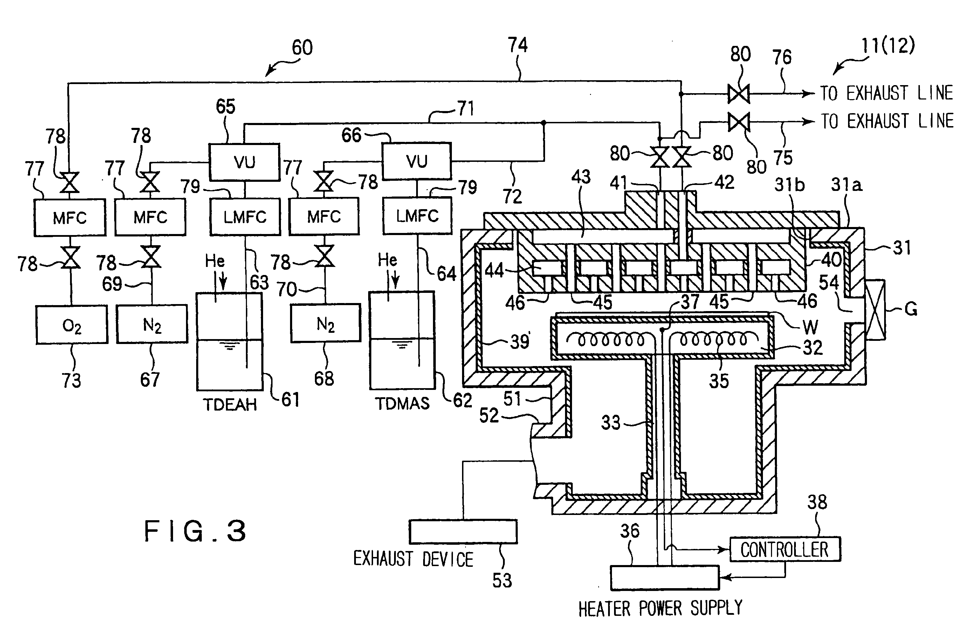

Fig. 3 is a cross sectional view showing the film forming apparatus 11. The film forming apparatus 11 has a substantially cylindrical chamber 31 constituted in an airtight manner in which a susceptor 32 for horizontally supporting a wafer W to be treated is disposed while supported by a cylindrical support member 33 that is disposed to a central lower portion of the susceptor 32. The susceptor 32 is formed of a ceramic material such as AIN. Further, a heater 35 is buried in the susceptor 32 and heater 35 is connected to a heater power source 36. On the other hand, thermocouple 37 is disposed near the upper surface of the susceptor 32, and the signal from the thermocouple 37 is transmitted to a controller 38. Then, the controller 38 sends an instruction in accordance with the signal from the thermocouple 37 to the heater power source 36 to control the heating performed by the heater 35 and control the wafer W to a predetermined temperature.

A quartz liner 39 is formed on the inner wall of the chamber 31 and the outer circumference of the susceptor 32 and the support member 33 for preventing accumulation of deposits. A purge gas (shield gas) is caused to flow between the quartz liner 30 and the chamber 31 thereby preventing deposits from accumulating to the wall portions to prevent contamination. Further, the quartz liner 39 is made detachable such that maintenance in the inside of the chamber 31 is conducted efficiently.

A circular hole 31b is formed to the top wall 31a of the chamber 31, in which a shower head 40 protruding therefrom into the chamber 31 is fitted. The shower head 40 is for discharging a gas for film formation supplied from a gas supply mechanism 60 (described later) to the inside of the chamber 31, and it has, at an upper portion thereof, a first introduction channel 41 for introducing an organic metal raw gas and a second introduction channel 42 for introducing oxygen gas as an oxidizer. In the shower head 40, spaces 43 and 44 are formed in two upper and lower stages. The upper space 43 is in contiguous with the first introduction channel 41, and a first gas discharge channel 45 extends from the space 43 to the bottom of the shower head 40. The lower space 44 is in contiguous with the second introduction channel 42, and a second gas discharge channel 46 extends from the space 44 to the bottom of the shower head 40. That is, the shower head 40 is adopted as a post-mix type for diffusing the metal raw gas and the oxidizer uniformly in the spaces 43 and 44 without mixing them and for separately discharging them from the discharging channels 45 and 46 respectively.

An exhaust chamber 51 protruding downward is provided at the bottom wall of the chamber 31. An exhaust pipe 52 is connected to the lateral surface of the exhaust chamber 51, and an exhaust device 53 is connected with the exhaust pipe 52. By operating the exhaust device 53, the inside of the chamber 31 can be depressurized to a predetermined vacuum degree.

A loading-unloading port 54 for loading and unloading the wafer W to and from the wafer transport chamber 15, and a gate valve G for opening or closing the loading-unloading port 54 are disposed to the side wall of the chamber 31.

The gas supply mechanism 60 has a hafnium raw material tank 61 for storing TDEAH as a hafnium raw material, a silicon raw material tank 62 for storing TDMAS as a silicon raw material, N₂ gas supply sources 67 and 68 for supplying N₂ gas as a carrier gas, and an oxygen gas source 73 for supplying O₂ gas as the oxidizer. The hafnium raw material and the silicon raw material can be used by being diluted in an organic solvent such as octane. As a carrier gas, N₂ gas may also be used.

A pumping gas such as He gas is introduced into the hafnium raw material tank 61, and a liquid TDEAH therein is introduced by way of a pipeline 63 to a vaporization unit 65. On the other hand, a pumping gas such as He gas is introduced also to the silicon raw material tank 62, and the liquid TDMAS therein is introduced by way of a pipeline 64 to a vaporization unit 66.

TDEAH vaporized in the vaporization unit 65 is transported in a pipeline 71 by N₂ gas introduced from the N₂ gas supply source 67 by way of the pipeline 69 into the vaporization unit 65. On the other hand, TDMAS vaporized in the vaporization unit 66 is transported in the pipeline 72 by the N₂ gas introduced from the N₂ gas supply source 68 by way of the pipeline 70 to the vaporization unit 66. Then, the pipeline 72 is connected with the pipeline 71 and vaporized TDEAH and TDMAS are joined in the pipeline 71 and introduced to the first introduction channel 41 of the shower head 40. Instead of the N₂ gas, other inert gas such as Ar gas may also be used.

The O₂ gas source 73 for supplying the O₂ gas as the oxidizer is connected with a pipeline 74, and the O₂ from the O₂ source 73 is transported through the pipeline 74 and introduced to the second introduction channel 42 of the shower head 40. As the oxidizer, ozone, clean air, radical oxygen, NO gas, N₂O gas, NO₂ gas, etc. can be used in addition to the O₂ gas.

The pipelines 69, 70, and 74 for conveying the gases are provided each with two valves 78 and a mass flow controller 77 that is placed between the two valves 78. Pre-flow pipelines 75, 76 connected with exhaust lines respectively are branched from the pipelines 71, 74. Valves 80 are disposed to the pipelines 71, 74 near the shower head 40 and near the branch points of pre-flow pipelines 75, 76. Further, liquid mass flow controllers 79 are disposed to the pipelines 63, 64 for transporting the liquid.

In the film forming apparatus constituted as described above, the inside of the chamber 31 is evacuated at first to render the pressure of about 80 to 800 Pa and the wafer W is heated by the heater 35 to 450 to 700°C, preferably, 500 to 650°C.

In this state, TDEAH from the hafnium raw material tank 61 is vaporized by the vaporization unit 65 and TDMAS from the silicon raw material tank 62 is vaporized by the vaporization unit 66 and they are caused to flow to the pre-flow line 75, while the O₂ gas from the O₂ supply source 73 is caused to flow to the pre-flow line 76 and preflowing is conducted for a predetermined time. Then, the valves 80 are switched to supply TDEAH and TEMAS to the first introduction channel 41 while the O₂ gas is supplied to the second introduction channel 42 and they are discharged respectively from the first gas discharge channel 45 and the second gas discharge channel 46, to start film formation. Thus, oxidizing reaction for TDEAH and TDMAS are taken place over the heated wafer W and a hafnium silicate film is formed on the wafer W.

The gas flow rates in this case are, for example, about 0.015 to 0.5 mL/min for TDEAH (liquid), 0.015 to 0.6 mL/min for TDMAS (liquid), 0 to 900 mL/min for each N₂ gas, and 100 to 1000 mL/min for O₂ gas. Further, the pressure in the chamber 31 upon film formation is, for example, 80 to 800 Pa.

As described above, by using TDEAH as the amide type organic hafnium compound and TDMAS as the amide type organic silicon compound, a hafnium silicate film with an extremely small surface roughness as described above can be formed.

Process conditions upon forming the hafnium silicate film described above is to be described specifically.

### (1) Effect of film formation temperature

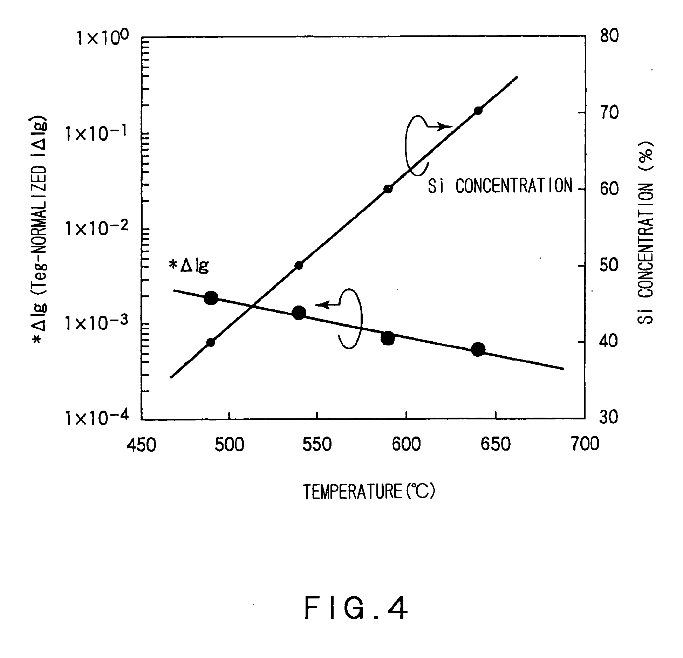

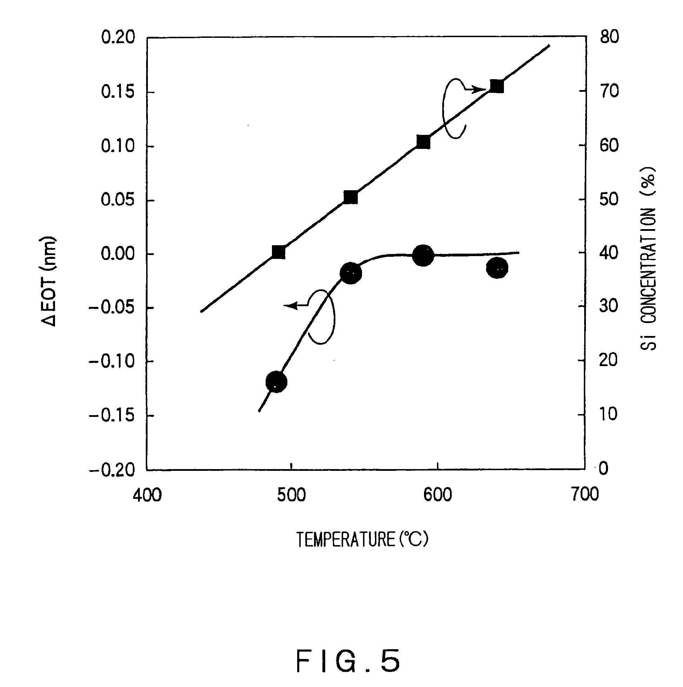

Fig. 4 is a graph taking the temperature upon film formation on the abscissa and taking a normalized leakage current value Δlg* obtained by normalizing the leakage current value based on SiO₂ (Δlg = lg/lg SiO₂) with the SiO₂ equivalent oxide thickness EOT and the Si concentration of the hafnium silicate film on the ordinate and showing the relationship of them. Further, Fig. 5 is a graph taking the film formation temperature on the abscissa and ΔEOT obtained by subtracting EOT (EOT_{std}) under a standard condition from the value of EOT, and the Si concentration of the hafnium silicate film on the ordinate and showing the relationship of them. The process conditions other than the temperature are as follows. Pressure: 280 Pa; Pre-flow O₂ flow rate: 2.5 L/min; TDEAH/TDMAS/O₂ flow rate: 56.3/56.3/500 (mL/min); Post treatment: oxidation with SPA (266 Pa, 10 sec) and nitridation (6.7 Pa, 360 sec) which are described later.

As shown in Fig. 4, as the film formation temperature is higher, the Si concentration in the hafnium silicate film increases, and the normalized leakage current value Δlg* lowers. That is, as the temperature is higher, the film quality is better. On the other hand, as shown in Fig. 5, in the case where the film formation temperature is 550°C or less, EOT tends to be lowered which is preferred for the reduction of the film thickness of the gate insulation film intended at present. However, as shown in Fig. 4, since the normalized leakage current value Δlg* increases as the film forming temperature is lowered, the film formation temperature is desirably as low as possible within an allowable range for the leakage current, preferably, from 550 to 550°C, from the point of view described above.

To make the reduction of the film thickness and the lowering of the leakage current compatible, it may be considered a two step film formation of forming an Si-rich film, for example, at 600°C or higher as the first state and then forming an Hf-rich film, for example, at 550°C or less as the second stage.

### (2) Effect of film forming pressure

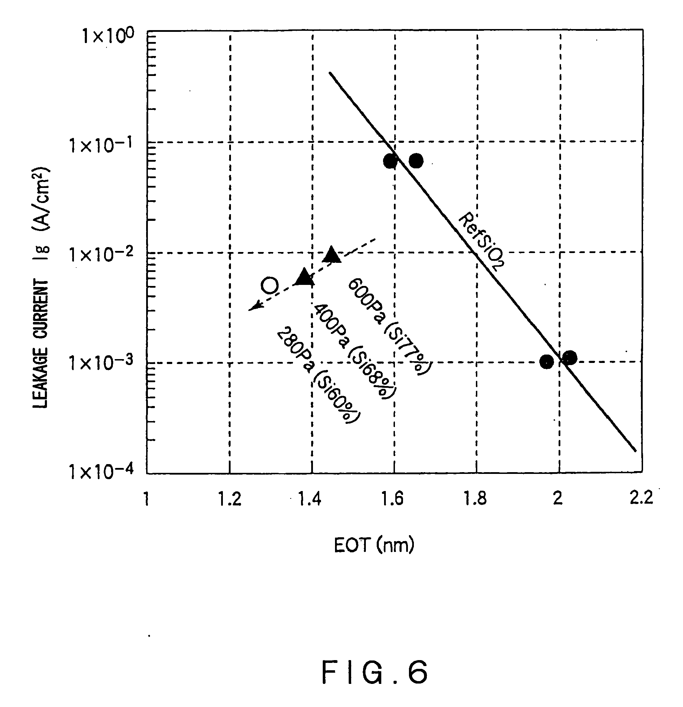

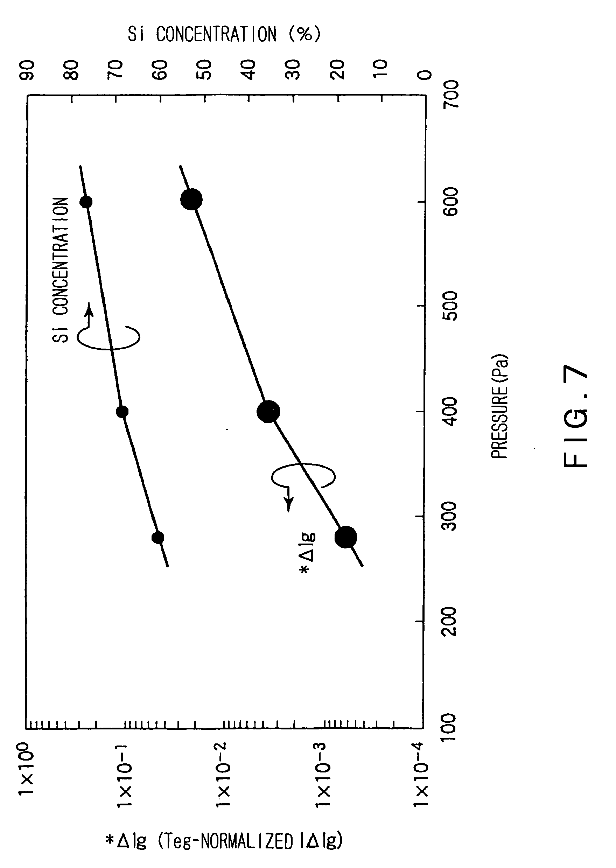

Fig. 6 is a graph taking EOT on the abscissa and a leakage current value on the ordinate and showing the relationship between them in the case of changing the pressure in the chamber upon film formation. Fig. 7 is a graph taking a pressure upon film formation on the abscissa and taking a normalized leakage current value Δlg* and a Si concentration of a hafnium silicate film on the ordinate and showing the relationship between them. In this case, the process conditions other than the pressure are identical with those in Fig. 4 excepting that the temperature is at 590°C.

The graphs show a trend that the Si concentration in the hafnium silicate film increases as the film forming pressure increases, and EOT and the normalized leakage current Δlg* are decreased as the pressure is lowered. At 600 Pa or lower, EOT is 1.45 nm or less and at 400 Pa or less EOT lowers to 1.4 nm or less. Further, also the leakage current tends to be decreased at 600 Pa or less. Accordingly, the pressure in the chamber upon film formation is, preferably, 600 Pa or less and, more preferably, 400 Pa or less. The pressure has no particular lower limit and it is actually about 100 Pa.

### (3) Effect of oxygen partial pressure

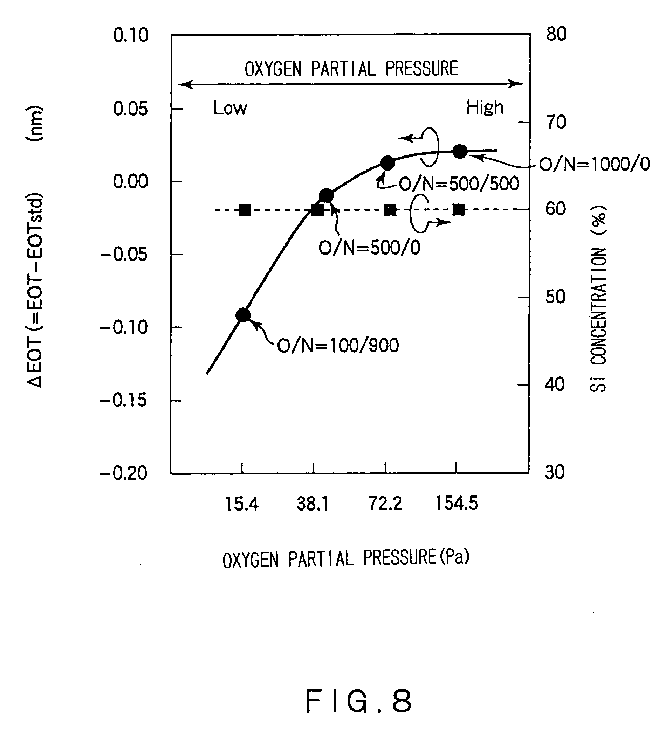

Fig. 8 is a graph taking an oxygen partial pressure on the abscissa and taking the ΔEOT and the Si concentration on the ordinate and showing the relationship between them. As shown in the graph, as the oxygen pressure is lowered, the EOT can be decreased in the thickness. Particularly, reduction of the EOT is remarkable at the oxygen pressure of 40 Pa or less. However, the Si concentration in the hafnium silicate film scarcely changes depending on the oxygen partial pressure and the value of the normalized leakage current value Δlg* scarcely changes even when the oxygen partial pressure is changed.

### (4) Effect of raw material flow rate ratio

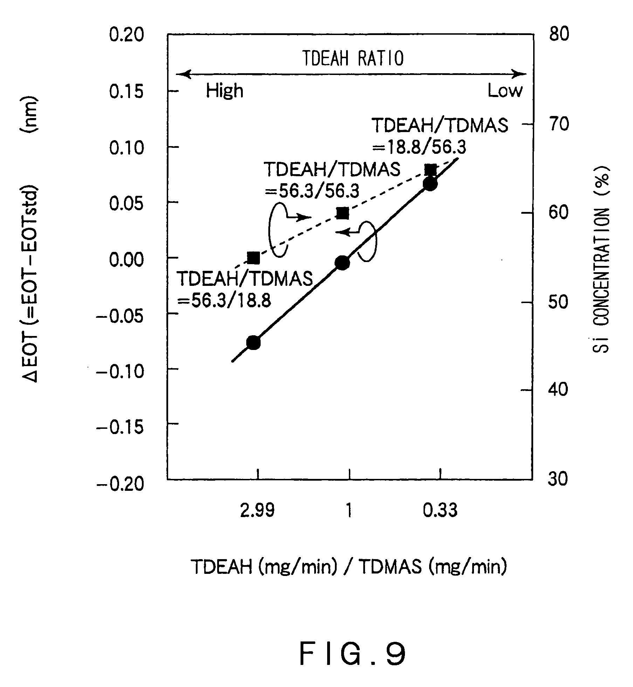

Fig. 9 is a graph taking a TDEAH/TDMAS flow rate ratio on the abscissa and the ΔEOT and the Si concentration on the ordinate and showing the relationship between them. As shown in the graph, it can be seen that the EOT can be decreased more in the thickness as TDEAH increases. From the view point, the TDEAH/TDMAS flow rate ratio is preferably 1 or more. Also the Si concentration in the film changes within a range from 55 to 75% depending on the TDEAH/TDMAS flow rate ratio.

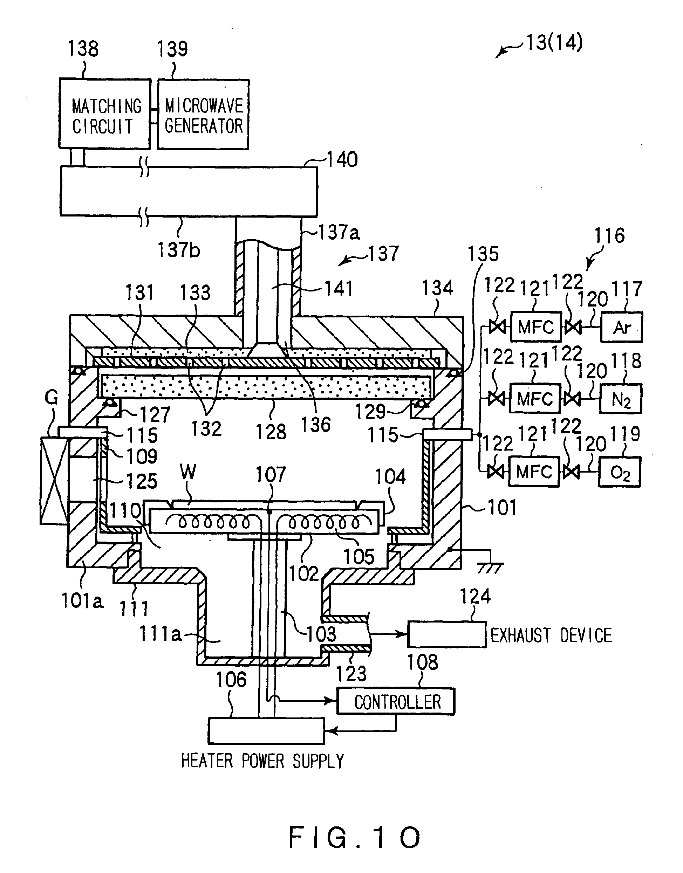

Then, a plasma treatment apparatus 13 for applying the plasma oxidation treatment in step 3 and the plasma nitriding treatment in step 4 is to be described. Fig. 10 is a cross sectional view showing the plasma treatment apparatus 13.

The plasma treatment apparatus 13 conducts an oxidation treatment and a nitriding treatment with microwave plasma. The plasma treatment apparatus 13 has a substantially cylindrical chamber 101 constituted in an airtight manner and electrically grounded. A circular opening 110 is formed about at the central portion of the bottom wall 101a of the chamber 101, and an exhaust chamber 111 in communication with the opening 110 and protruding downwards is provided to the bottom wall 101a. A susceptor 102 comprising a ceramic material such as AIN is provided in the chamber 101 for horizontally supporting a wafer W as a substrate to be treated in the chamber 101. The susceptor 102 is supported by a cylindrical support member 103 comprising a ceramic material such as AIN extending upward from the center at the bottom of the exhaust chamber 111. A guide ring 104 for guiding a wafer W is provided to the outer periphery of the susceptor 102. A heater 105 of a resistant heating type is buried in the susceptor 102 and the heater 105 is connected to a heater power source 106. Thermocouple 107 is provided near the upper surface of the susceptor 102 and signals from the thermocouple 107 are transmitted to a controller 108. The controller 108 is adapted to send an instruction in accordance with the signals from the thermocouple 107 to the heater power source 106, to control the heating performed by the heater 105 and control the wafer W to a predetermined temperature. In this case, the temperature can be controlled within a range of a room temperature to 800°C, for example. A cylindrical liner 109 made of quartz is disposed to the inner circumference of the chamber 101.

Wafer support pins (not illustrated) for supporting and elevating or descending the wafer W are disposed to the susceptor 102 such that they can be protruded or retracted from and into the surface of the susceptor 102.

An annular gas introduction member 115 is formed to the side wall of the chamber 101, and the gas introduction member 115 is connected with a gas supply system 116. The gas introduction member may be arranged in a shower-like arrangement. The gas supply system 116 has an Ar gas supply source 117, an N₂ gas supply source 118, and an O₂ gas supply source 119 and the gases are sent by way of the gas lines 120 to the gas introduction member 115 and introduced from the gas introduction member 115 into the chamber 101. Each of the gas lines 120 is provided with a mass flow controller 121 and on/off valves 122 disposed between the mass flow controller 121.

An exhaust pipe 123 is connected to the lateral surface of the exhaust chamber 111, and an exhaust pipe 123 is connected with an exhaust device 124 including a high speed vacuum pump. By operating the exhaust device 124, a gas in the chamber 101 is exhausted uniformly into the space 111a of the exhaust chamber 111 and exhausted by way of the exhaust pipe 123. Thus, the inside of the chamber 110 can be depressurized at a high speed to a predetermined vacuum degree, for example, 0.133 Pa.

A loading-unloading port 125 for loading and unloading a wafer W to and from the wafer transport chamber 15 and a gate valve G for opening or closing the loading-unloading port 125 are disposed to the side wall of the chamber 101.

The chamber 101 has an opening at an upper portion, and a ring-like support portion 127 is formed along the peripheral edge of the opening. A microwave transmissive plate 128 comprising a dielectric material, for example, quartz or ceramics such as Al₂O₃ and transmitting microwaves is disposed in an airtight manner to the support portion 127 by way of a seal member 129. Accordingly, the inside of the chamber 101 is maintained airtight.

A disk-shaped planar antenna member 131 is located above the microwave transmissive plate 128 so as to oppose to the susceptor 102. The planar antenna member 131 is engaged to the upper end on the side wall of the chamber 101. The planar antenna member 131 with a surface gold plated comprises, for example, a copper plate or an aluminum. A number of microwave radiation holes 132 penetrate through the planar antenna member 131 with a predetermined pattern. The microwave radiation hole 132 comprises a slot of an elongated groove shape. Adjacent slots are arranged in a T shape, and the plurality of slots are arranged in a concentric pattern. The microwave radiation hole 132 may be in other shapes such as circular through hole, etc. A wave retarding member 133 having a dielectric constant greater than that of a vacuum space is disposed to the upper surface of the planar antenna member 131. A shield lid 134 comprising a metal material, for example, aluminum or stainless steel is provided to the upper surface of the chamber 101 so as to cover the planar antenna member 131 and the wave retarding member 133. The upper surface of the chamber 101 and the shield lid 134 are sealed by a sealing member 135. The shield lid 134 is provided therein with a coolant flow channel (not illustrated). By flowing cooling water through the coolant flow channel, the planar antenna 131, the microwave transmissive plate 128, the wave retarding material member 133, and the shield lid 134 are cooled. The shield lid 134 is electrically grounded.

An opening 136 is formed at the center of the upper wall of the shield lid 134, and a waveguide tube 137 is connected to the opening. A microwave generator 139 is connected by way of a matching circuit 138 to the end of the waveguide tube 137. Thus, a microwave with a frequency, for example, of 2.45 GHz generated by the microwave generator 139 is transmitted by way of the waveguide tube 137 to the planar antenna member 131. As the frequencies of the microwaves, 8.35 GHz, 1.98 GHz, etc. can also be used.

The waveguide 137 has a coaxial waveguide tube 137a of a circular cross section extending upward from the opening 136 of the shield lid 134 and a rectangular waveguide tube 137b of a rectangular cross section extending in the horizontal direction connected to the upper end of the coaxial waveguide tube 137a. The end of the rectangular waveguide tube 137b on the connection side with the coaxial waveguide tube 137a constitutes a mode converter 140. An inner conductor 141 extends at the center of the coaxial waveguide tube 137a and the lower end of the inner conductor 141 is connected and fixed to the center of the planar antenna member 131.

In the plasma treatment apparatus 13 constituted as described above, the gate valve G is opened, and a wafer W formed with a hafnium silicate film is loaded from the loading-unloading port 125 into the chamber 101 and placed on the susceptor 102.

At first, a plasma oxidation treatment is applied to the hafnium silicate film formed to the wafer W. In the plasma oxidation treatment, Ar gas and O₂ gas are introduced each at a predetermined flow rate from the Ar gas supply source 117 and the O₂ gas supply source 119 of the gas supply system 116 by way of the gas introduction member 115 into the chamber 110 and maintained at a predetermined pressure. The process conditions in this case are, for example, as follows. Ar gas flow rate: 2000 mL/min; O₂ gas flow rate: 200 mL/min; Pressure in the chamber: 6.7 to 267 Pa, for example, 267 Pa.

Then, microwaves from the microwave generator 139 are introduced by way of the matching circuit 138 to the waveguide tube 137. The microwaves are supplied through the rectangular waveguide tube 137b, the mode converter 140, and the coaxial waveguide tube 137a to the planar antenna member 131, and emitted from the planar antenna member 131 by way of the microwave transmission plate 128 to the space above the wafer W in the chamber 101. The microwaves are propagated in a TE mode in the rectangular waveguide tube 137b and the microwaves in the TE mode are converted by the mode converter into a TEM mode and propagated into the coaxial waveguide tube 137a in the direction of the planar antenna 131.

The Ar gas and the O₂ gas are formed into plasma in the chamber 101 by the microwaves radiated from the transmission hole 132 of the planar antenna member 131 by way of the microwave transmission platen 128 to the chamber 101, and the hafnium silicate film is subjected to the oxidation treatment with the plasma. The microwave plasma is with a plasma density of about 10¹²/cm³ or more and with an electron temperature of about 1.5 eV or lower, and can be applied to the oxidation treatment at a low temperature in a short time. In addition, the microwave plasma also has a merit that it gives less plasma damage due to ions to the base film, etc. With the treatment, oxygen defects in the hafnium silicate plate are buried, and remaining impurities such as C are removed. Further, a thin oxide film is formed at the boundary between the wafer and the hafnium silicate film to make the boundary smooth.

Successively, a plasma nitriding treatment is applied to the hafnium silicate film after applying the plasma oxidation treatment. In the plasma nitriding treatment, an Ar gas and an N₂ gas are introduced each at a predetermined flow rate from the Ar gas supply source 117 and the N₂ gas supply source 118 of the gas supply system 116 by way of the gas introduction member 115 into the chamber 101 and maintained at a predetermined pressure. The conditions in this case are, for example, as follows. Ar gas flow rate: 1000 mL/min; N₂ gas flow rate: 40 mL/min; and Pressure in the chamber: 6.7 to 127 Pa, for example, 6.7 Pa.

Then, in the same manner as in the case of the plasma oxidation treatment, microwaves are radiated into the chamber 101 to convert the Ar gas and the N₂ gas into plasma and the hafnium silicate film is subjected to the nitriding treatment with the plasma. Also in this case, the formed plasma is with a high density and with a low electron temperature and the nitriding treatment can be conducted at a low temperature in a short time. In addition, the plasma gives less plasma damages to the base film. The treatment can prevent the hafnium silicate from being phase-separated into HfO₂ and SiO₂, and the dielectric constant is further increased by nitridation.

Then, the experimental result in which the effect of the present embodiment is confirmed will be described. After conducting diluted hydrofluoric acid cleaning to the surface of the silicon wafer in step 1 in accordance with the procedures described above, film formation of the hafnium silicate film in step 2, plasma oxidation treatment in step 3 and plasma nitriding treatment in step 4 are conducted by using the apparatus shown in Figs. 2 to 4 under various conditions to form a gate insulation film.

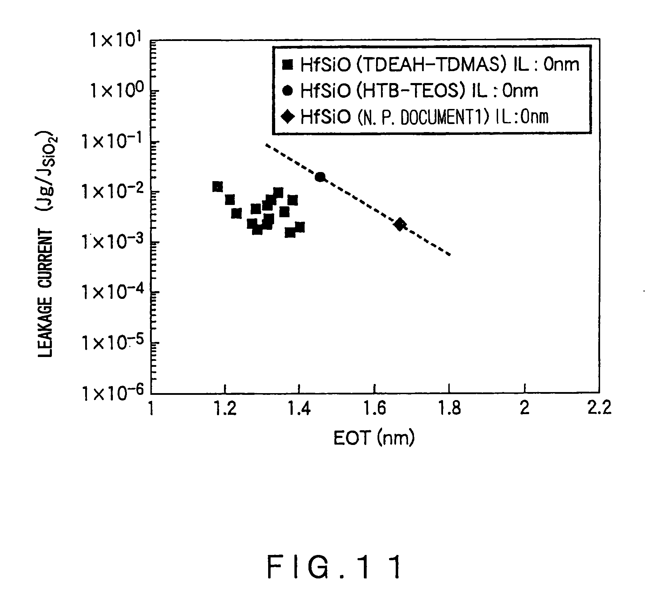

For the gate insulation films, the surface roughness was measured and EOT and leakage current were determined. For comparison, the EOT and the leakage current were determined in the same manner also for a gate insulation film obtained by forming a hafnium silicate film by directly using HTB and TEOS without a underlying layer disposed on the silicon wafer and applying the plasma oxidation treatment and the plasma nitriding treatment in the same manner (under the same conditions as those in Non-Patent Document 1 and different conditions). The result is shown in Fig. 11. The value for the leakage current is obtained by normalizing by junction leak of SiO₂. Further, in Fig. 11, IL represents an underlying layer (interlayer) between the substrate and the hafnium silicate film.

In gate insulation films that meet the conditions of the present embodiment, it was confirmed that the surface roughness showed an extremely small value from 0.20 to 0.25 nm as the center surface roughness, the leakage current value was at an allowable level even when the SiO₂ equivalent oxide thickness (EOT) was 1.4 nm or less, and the leakage current was lower at a thin film thickness compared with the insulation film to be compared.

### [Second Embodiment]

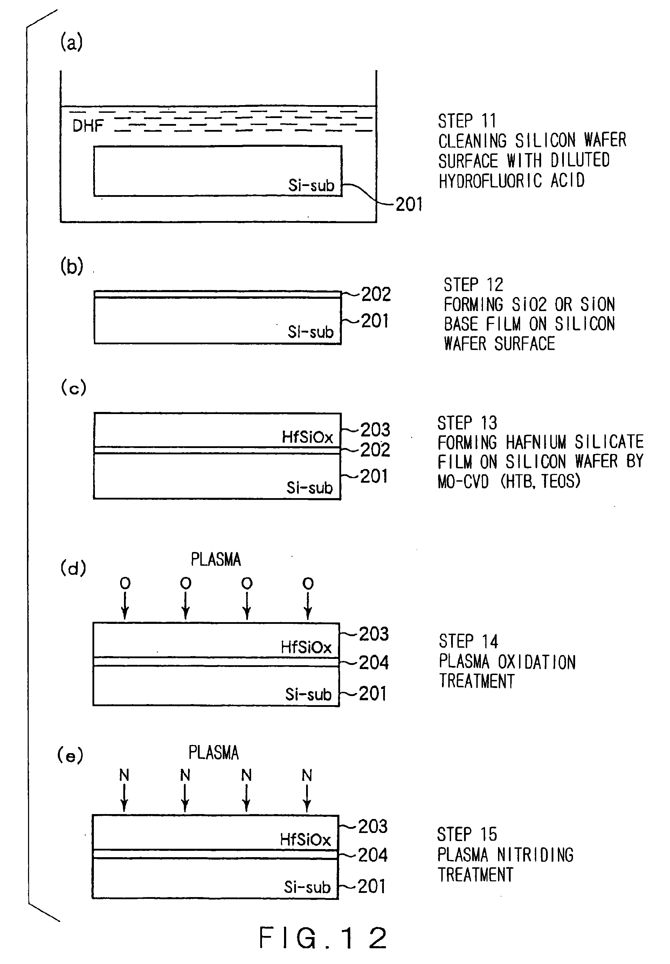

Figs. 12A to 12E are views for explaining steps of forming a gate insulation film according to a second embodiment of the present invention.

In the present embodiment, as shown in Fig. 12A, first, a silicon wafer 201 is dipped, for example, in a diluted hydrofluoric acid (DHF) solution thereby cleaning the surface of the silicon wafer 201 such that oxygen is not substantially present on the surface (step 11) in the same manner as in the first embodiment.

Then, as shown in Fig. 12B, a base film 202 comprising a silicon oxide (SiO₂) film or a silicon oxynitride (SiON) film is formed on the cleaned surface of the silicon wafer 201 (step 12). Although the film forming method in this case is not restricted, UV-ray excited radical oxidation treatment or UV-ray excited radical oxynitriding treatment is preferred since the film can be formed at a low temperature in a short time and gives no damages to the underlying layer. The film forming method may be an oxidation treatment or oxynitriding treatment with remote plasma. Further, the UV-ray excited radical oxidation treatment and the remote plasma nitriding treatment may also be combined. Further, an oxidation treatment or oxynitriding treatment with plasma with a high density and a low electron temperature using a slot antenna such as a radial slot antenna can also be adopted. Alternatively, inductively coupled plasma (ICP), surface reflection wave plasma, and magnetron plasma can also be used. The thickness of the base film in this case is preferably 0.4 nm or more. Although the upper limit for the film thickness is not present in view of the surface roughness, about 0.8 nm is the actual upper limit from a view point of capacitance and super micro-miniaturization. Also, in the case of forming the base film only by the nitriding treatment, EOT can be lowered compared with the case where base film is not present.

The conditions for the UV-ray excited radical oxidation treatment (UVO) are, for example, as follows. Gas: O₂; Flow rate: 50 to 4000 mL/min; Pressure: 1.33 to 665 Pa; Temperature: 300 to 750°C; and Time: 15 to 600 sec. Preferred conditions are as follows. Flow rate: 200 to 2000 mL/min; Pressure: 1.33 to 133 Pa; Temperature: 450 to 700°C; and Time: 30 to 90 sec.

The conditions for the UV-ray excited radical oxynitriding treatment (UVNO) are, for example, as follows. Gas: NO; Flow rate: 10 to 1000 mL/min; Pressure: 0.13 to 665 Pa; Temperature: 300 to 750°C; and Time: 15 to 600 sec. Preferred conditions are as follows. Flow rate: 50 to 100 mL/min; Pressure: 0.13 to 133 Pa, Temperature: 450 to 750°C, and Time: 30 to 90 sec.

The conditions for the nitriding treatment with remote plasma (RFN) are, for example, as follows. Gas: Ar and N₂; Ar+N₂ total flow rate: 500 to 2500 mL/min; Ar/N₂ flow rate ratio: 2 to 200; Pressure: 0.13 to 1333 Pa; Temperature: 300 to 750°C; and Time: 10 to 180 sec. Preferred conditions are as follows. Flow rate: 1400 to 2000 mL/min; Pressure: 0.13 to 133 Pa, Temperature: 450 to 700°C; and Time: 10 to 90 sec.

The conditions for the oxidation treatment by remote plasma (RFO) are, for example, as follows. Gas: Ar and O₂; Ar+O₂ total flow rate: 500 to 2500 nm/min; Ar/O₂ flow rate ratio: 2 to 200; Pressure: 0.13 to 133 Pa; Temperature: 300 to 750°C; and Time: 10 to 180 sec.

The conditions for the oxynitriding treatment with remote plasma (RFNO) are, for example, as follows. Gas: Ar and NO; Ar+NO total flow rate: 500 to 2500 nm/min; Ar/No flow rate ratio: 2 to 200; Pressure: 0.13 to 1333 Pa; Temperature: 300 to 750°C; and Time: 10 to 180 sec.

In the actual formation of the base film, only one of the foregoing treatments is conducted; or some of the foregoing treatments are appropriately combined.
If it is conducted at a low temperature (LT), the treatment(s) and the conditions therefor may typically be any one of the followings:
LTUVO treatment (Gas: O₂; Flow rate: 450 mL/min; Pressure: 13.3 Pa; Temperature: 450°C; Time: 60 sec);
LTUVNO treatment (Gas: NO; Flow rate: 100 mL/min; Pressure: 4 Pa; Temperature: 450°C; Time: 60 sec);
LTRFN treatment (Gas: Ar and N₂; Flow rate: Ar/N₂ = 1300/200 mL/min; Pressure: 26.6 Pa; Temperature: 450°C; Time: 30 sec);
a combination of LTUVO2 treatment and LTRFN treatment (LTUVO step: 60 sec; RFN step: 30 sec);
a combination of LTUVNO treatment and LTRFN treatment (LTUVNO step: 60 sec; LTRFN step: 30 sec); and
a combination of LTRFN and LTUVO (RFN step: 30 sec, LTUVO step: 60 sec).

If conducted at a high temperature (HT), the treatment(s) and the conditions therefor may typically be any one of the followings:
HTUVO treatment (Gas: O₂; Flow rate: 200 mL/min; Pressure: 2.7 Pa; Temperature: 700°C; Time: 60 sec);
HTUVNO treatment (Gas: NO; Flow rate: 50 mL/min; Pressure: 1.1 Pa, Temperature: 700°C; Time: 30 sec);
HTRFN treatment (Gas: Ar and N₂; Flow rate: Ar/N₂ = 1930/20 mL/min; Pressure: 26.7 Pa; Temperature: 700°C; Time: 30 sec);
a combination of HTUVO treatment and HTRFN treatment (HTUVO2 step: 60 sec; HTRFN step: 30 sec);
a combination of HTUVNO treatment and HTRFN treatment (LTUVNO step: 30 sec; REN step: 30 sec); and
a combination of LTRFM treatment and LTUVO treatment (RFN step: 30 sec; LTUVO step: 60 sec).

Following the formation for the base film, as shown in Fig. 12(c), a hafnium silicate (HfSiOₓ) film 203 is formed by CVD using organic metal (MO-CVD) (step 13). In this case, an alkoxide type organic hafnium compound, for example, HTB (hafnium tertiary butoxide) same as that in Non-Patent document 1 is used as the hafnium raw material, and an alkoxide type organic silicon compound, for example, TEOS (tetraethoxy silane) same as that in the Non-Patent Document 1 is used as the silicon raw material.

The molecular structure of HTB and TEOS are as shown in the following formulas (3) and (4), respectively. The symbols Hf and Si at the center of each molecule are each bonded with four O. In HTB, tertiary butyl group is bonded to each O. In TEOS, an ethyl group is bonded to each O. Since they contain O in the molecule, an oxidizer is preferably used although a hafnium silicate film can be formed without using an oxidizer.

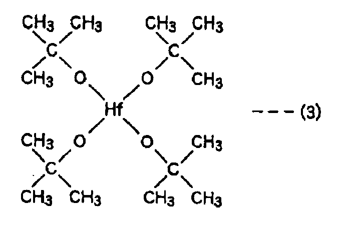

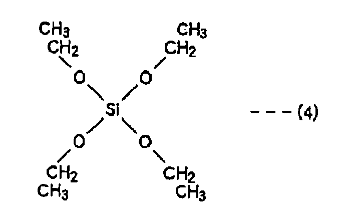

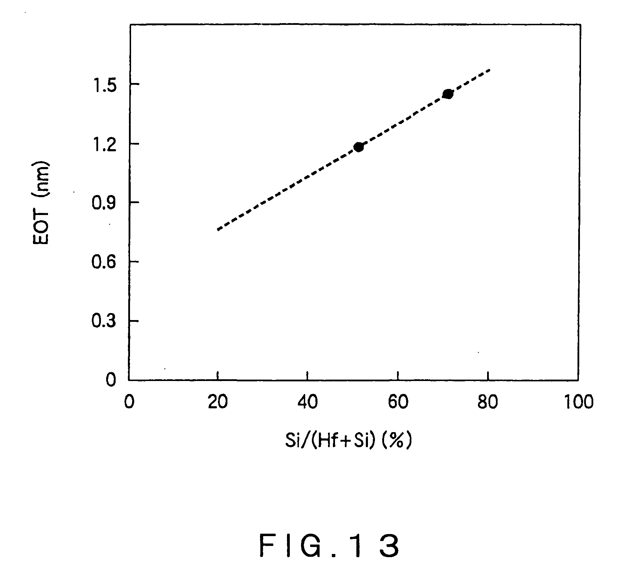

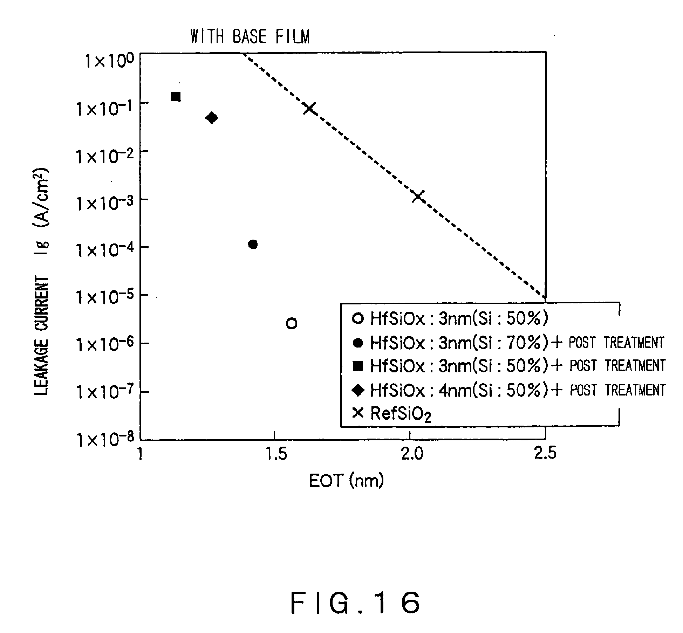

From a view point of further reduction of the SiO₂ equivalent oxide thickness (EOT), the hafnium silicate film is preferably Hf-rich. This is shown in Fig. 13. In the graph, a black circle (Si concentration: 70%) and a black square (Si concentration: 50%) in Fig. 16 to be described later are arranged in view of the relationship between the Si concentration and EOT. The thickness of the hafnium silicate is 3 nm. From the graph, it can be seen that EOT is decreased more in the Hf-rich state in the case of using HTB and TEOS. Since EOT is 1.45 nm when the Si concentration (Si/(Hf+Si)) is 70%, the Si concentration (Si/(Hf+Si)) is preferably 70% or less. However, since it is difficult to obtain the hafnium silicate in the case where the Si concentration is excessively low, the substantial lower limit for the Si concentration is 10%.

As shown in Fig.12D, a plasma oxidation treatment is applied to a hafnium silicate film 203 formed as described above (step 14). The plasma oxidation treatment acts to bury oxygen defects in the hafnium silicate film 203, eliminate remaining impurities such as C, grow an oxide film at the Si substrate boundary to form an oxide film 204 integrated with the base film 202 to make the boundary homology satisfactory. In order not to damage the hafnium silicate film 203, it is preferred to use plasma with a low electron temperature and with a high density for the plasma oxidation treatment. In the present embodiment, since the base film 202 is formed previously, this step is not essential.

Successively, as shown in Fig. 12(e), a plasma nitriding treatment is applied to the hafnium silicate film 2 that has been applied to the plasma oxidation treatment (step 15). Like the plasma nitriding treatment in step 4 of the first embodiment, the plasma nitriding treatment acts to prevent phase separation of hafnium silicate into HfO₂ and SiO₂, and increase the dielectric constant further by nitridation. Also, for the plasma nitriding treatment, plasma at a low electron temperature and at a high density is preferably used in order not to damage the hafnium silicate film 203.

In the present embodiment, a gate insulation film 4 of 1.45 nm or less in EOT (SiO₂ equivalent oxide thickness) is formed by such a series of steps.

As described above, in the present embodiment, prior to the formation of the hafnium silicate film 203 in step 13, a base film 202 comprising silicon oxide or silicon oxynitride is formed in step 12. According to the experiment made by Inumiya, et al. in the Non-Patent Document 1, it is described that the leakage current characteristics are not improved even when such a base film is formed. However, it has been found that so long as the thickness of the gate insulation film is in a region as thin as 1.4 nm or less in EOT (SiO₂ equivalent oxide thickness), the surface roughness of the hafnium silicate film could be decreased by providing the base film even when the alkoxide series raw material same as that used by Inumina, et al. was used.

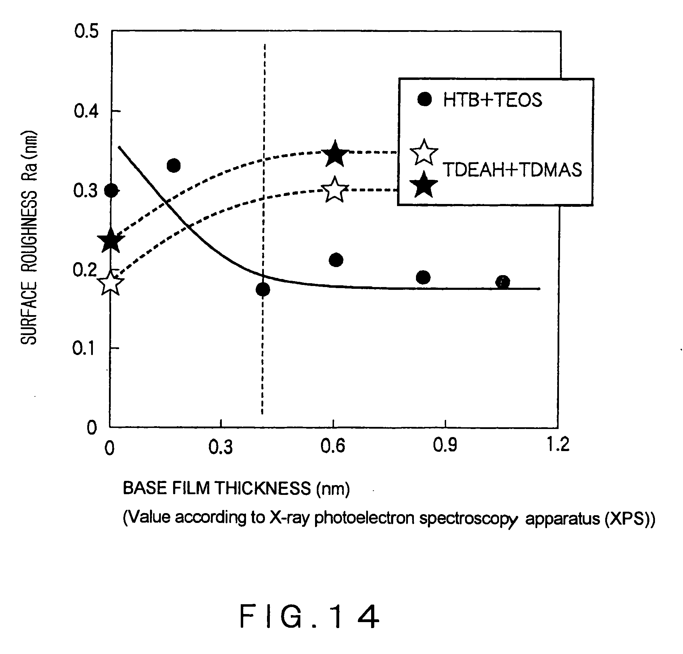

This is to be described with reference to Fig. 14. Fig. 14 is a graph taking the thickness of the base film 202 on the abscissa and taking the centerline surface roughness Ra of the hafnium silicate film on the ordinate and showing the relationship between them. The graph shows the case of using an alkoxide series material (HTB and TEOS) as the material for forming the silicate and the case of using an amide series material (TDEAH and TDMAS) used in the first embodiment. As apparent from the graph, it was found that in the case of using HTB and TEOS, the surface roughness exceeded 0.3 nm in Ra in the case where the base film 202 was not present, whereas the surface roughness was lowered as the thickness of the base film 202 increases and Ra was lowered to 0.2 nm at the film thickness of 0.4 nm or more of the base film 202. On the contrary, for TDEAH and TDMAS used in the first embodiment, it can be seen that the surface roughness rather increases by providing the base film while the surface roughness was small in the case of directly forming a film to the silicon wafer after the hydrofluoric acid treatment.

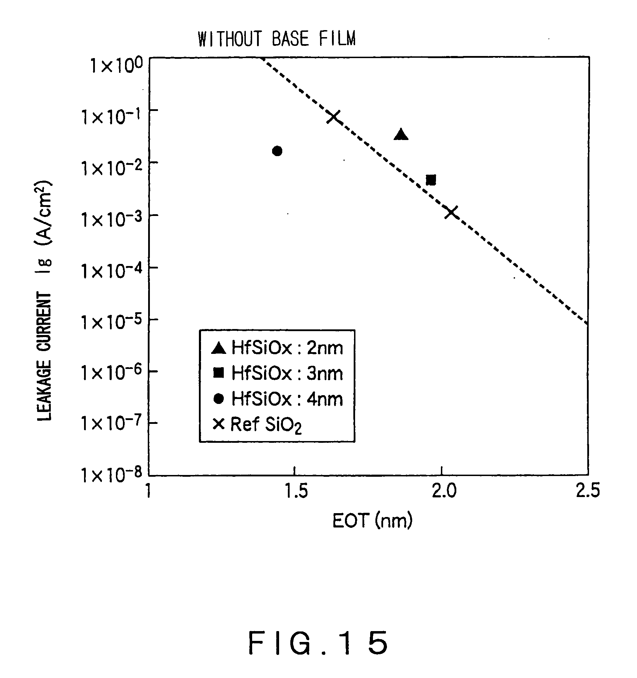

A description will be made of the results of measuring the leakage current in the case where the base film is provided and in the case where the base film is not provided. In the above two cases, the alkoxide series material (HTB and TEOS) is used as the material for forming the hafnium silicate film. Fig. 15 shows the relationship between the SiO₂ equivalent oxide thickness (EOT) and the leakage current in the case of cleaning the surface of a silicon wafer with 1 percent diluted hydrofluoric acid, then forming hafnium silicate films with a thickness of 2 nm, 3 nm, and 4 nm without providing the base film, and applying the plasma oxidation treatment and the plasma nitriding treatment using the apparatus shown in Fig. 10. Further, Fig. 16 shows the relationship between the SiO₂ equivalent oxide thickness (EOT) and the leakage current in the case of cleaning the surface of a silicon wafer with 1 percent diluted hydrofluoric acid, then forming a base film with a thickness of 0.6 nm with UV-ray excited radical oxidation treatment and remote plasma nitriding treatment, then forming hafnium silicate films with a thickness of 3 nm and 4 nm and applying the same post treatment and not applying such a post treatment.

As shown in Fig. 15, in the case of not providing the base film, EOT is not decreased and the leakage current is large since the hafnium silicate film with a thickness of 3 nm or less is low in quality. While EOT is somewhat decreased in the case of the film thickness of 4 nm, the EOT is about 1.5 nm, which is insufficient. On the contrary, as shown in Fig. 16, in the case of providing the base film, EOT can be lowered to 1.45 nm or less even when the thickness of the hafnium silicate film is 3 nm. The leakage current can be decreased for the same EOT.

As described above, in the present embodiment, by forming the base film with a thickness of 0.2 to 0.8 nm, preferably, 0.4 to 0.8 nm, the surface roughness of the gate insulation film can be about 0.2 nm in the center line roughness Ra even when the thickness of the gate insulation film is 1.45 nm or less in EOT, and the leakage current can be decreased even when the thickness of the gate insulation film is reduced.

In the present embodiment, the thickness of the gate insulation film is, preferably, 1.4 nm or less, more preferably, 1.2 nm or less and, further preferably, 1.0 nm or less in EOT. With the presence of the base film, a film with small surface roughness can be formed while the leakage current is within an allowable range even when the gate insulation film is as thin as described above.

For the apparatus of practicing the method of the present embodiment, the same system in Fig. 2 as in the first embodiment can be used. In the formation of the base film 202 in step 12, a device for conducting UV-ray excited radical oxidation treatment or a remote plasma treatment apparatus is, for example, provided instead of one of the film forming apparatuses 11, 12 and plasma treatment apparatuses 13, 14, and the base film 202 can be formed therein. In the case of using the oxidation in the UV-ray excited radical oxidation treatment and the nitridation in the remote plasma treatment apparatus in combination, the two devices may be mounted in stead of two of the film forming apparatuses 11, 12 and the plasma treatment apparatuses 13, 14. The base film 202 may of course be formed by using one of the plasma treatment apparatuses 13, 14.

Further, in the formation of the hafnium silicate film 203 in step 13, the film can be formed in the apparatus structure shown in Fig. 3 by storing HTB in the hafnium raw material tank 61 and storing TEOS in the silicon raw material tank 62. The film forming conditions in this case are, for example, as follows. Wafer temperature: 500°C; Pressure in the chamber: 40 to 400 Pa; HTB flow rate: 0.2 to 1 mL/min; TEOS flow rate: 0.1 to 5 mL/min; N₂ gas flow rate: 100 to 2,000 mL/min; and O₂ gas flow rate: 100 to 500 mL/min. HTB may also be used in the state of an octane solution.

The plasma oxidation treatment and the plasma nitriding treatment in steps 14, 15 can be conducted by using one of the plasma treatment apparatuses 13, 14 under the same conditions and procedures as those in the first embodiment.

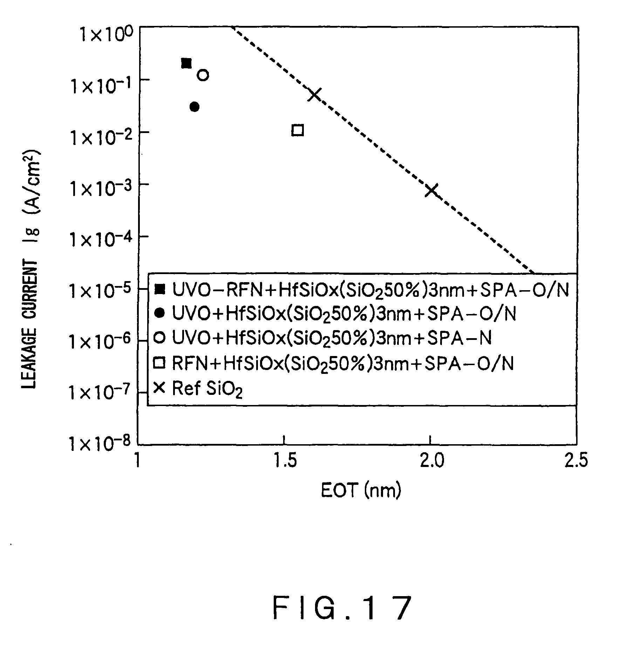

Next, a description will be made of the results of obtaining EOTs and leakage currents for each type of the base film forming treatments and the post treatments after film formation. Fig. 17 is a graph showing the results taking the EOT on the abscissa and the leakage current on the ordinate, and plotting them for each treatment. The EOT can be reduced without increasing the leakage current by using the UV-ray excited radical oxidation treatment (UVO), or the UV-ray excited radical oxidation treatment (UVO) plus the remote plasma nitriding treatment (RFN) upon forming the base film.

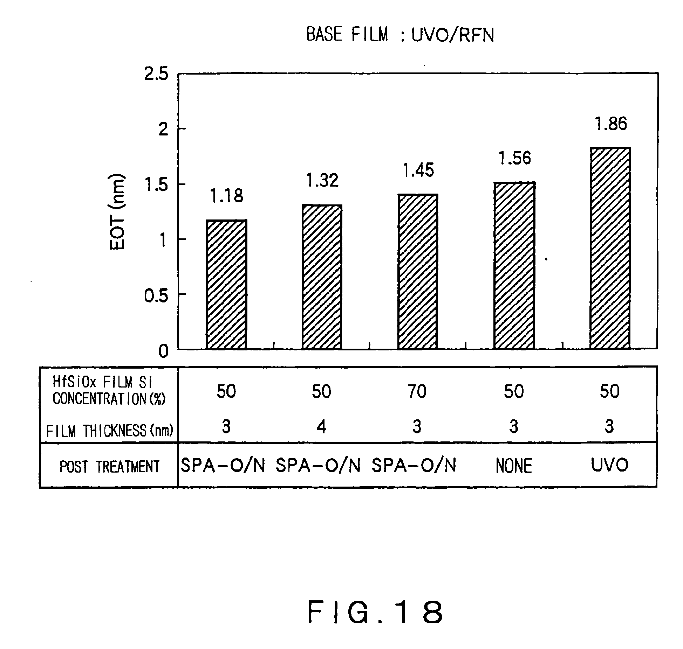

Next, a description will be made of the results of obtaining EOTs in the case of using the UV-ray excited radical oxidation treatment (UVO) and the remote plasma nitriding treatment (RFN) as the base film forming treatment and changing the post treatment after film formation, the film thickness (3 nm, 4 nm), and the Si concentration (50%, 70%) of the hafnium silicate film. Fig. 18 is a graph showing the values of EOTs in these cases. An experiment was conducted also in the case of using an oxidation treatment and a nitriding treatment by microwave plasma treatment (SPA-O/N) using a radial slot antenna (RLSA) and not conducting the post treatment. As shown in the graph, the EOT was 1.18 nm which is the lowest value when the thickness of the hafnium silicate film was 3 nm and the Si concentration was 50%, using SPA-O/N as the post treatment after film formation.

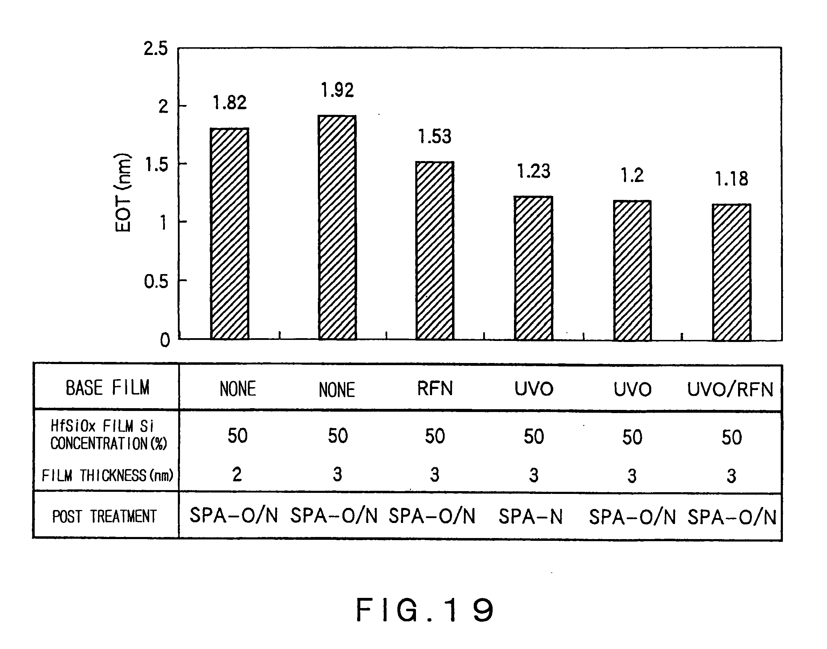

Next, a description will be made of the results of obtaining EOTs in the case of changing the base film forming treatment, post treatment after forming formation, and the thickness of the hafnium silicate film. Fig. 19 is a graph showing the values of EOTs in these cases. For the base film forming treatment, an experiment was conducted also in the case of using the remote plasma nitriding treatment (RFN), UV-ray excited radical oxidation treatment (UVO), and UVO/RFN treatment, without conducting the base film forming treatment. For the post-treatment after film formation, SPA-O/N and SPA-N were used. The film thickness was set to 2 nm and 3 nm and the Si concentration was set to 50% for the hafnium silicate film. From the graph, it was confirmed that while the EOT was not reduced in the case where no base film is provided, the EOT was reduced by properly forming the base film. Particularly, it can be seen that in the case of conducting the UVO treatment and the UVO/RFN treatment, the value of the EOT can be minimized.

Next, a description will be made of the results of the experiment in which the effect of the present embodiment has been confirmed. In this case, after conducting a diluted hydrofluoric acid cleaning to the silicon wafer surface in step 11 in accordance with the procedure described above, formation of the base film in step 12, formation of the hafnium silicate film in step 13, plasma oxidation treatment in step 14, and plasma nitriding treatment in step 15 were conducted using apparatus shown in Figs. 2 to 4, to form a gate insulation film.

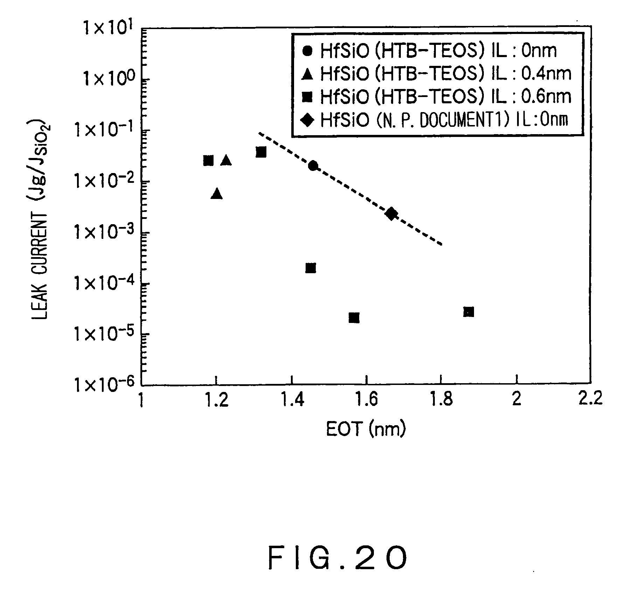

For the gate insulation films, the surface roughness was measured and the EOTs and leakage currents were obtained. For comparison, EOTs and leakage currents were obtained also for gate insulation films obtained by forming the hafnium silicate film directly on a silicon wafer by using HTB and TEOS, then conducting the plasma oxidation treatment and the plasma nitriding treatment in the same manner (under the same conditions as in Non-Patent Document 1 and different conditions). The results are shown in Fig. 20. The values of the leakage currents are obtained by normalizing by SiO₂ junction leak. As shown in Fig. 20, IL represents a base film (interlayer) between a substrate and a hafnium silicate film.

In the hafnium silicate film formed by using HTB and TEOS after providing the base film in accordance with the present embodiment, the surface roughness tended to be decreased and, particularly, it showed an extremely small value of about 0.20 nm in the center surface roughness when the thickness of the base film was 0.45 nm or more (refer to Fig. 14), and it was confirmed that the leakage current value was at an allowable level even when the SiO₂ equivalent oxide thickness was 1.4 nm or less as shown in Fig. 20 and that the leakage current was lower at a less film thickness as compared with the insulation film.

The present invention is not limited to the above embodiments and can be applied to various modifications. For example, although TDEAH was used as the hafnium raw material in the first embodiment, another amide type organic hafnium compound, for example, tetrakisethylmethylaminohafnium, tetrakisdimethylaminohafnium, and tetrakisisopropylaminohafnium may also be used. Further, although TDMAS, which is an amide type organic silicon compound, was used for the silicon raw material, it is not restricted but other silicon compounds such as TEOS, silane, disilane or the like may also be used.

Further, while HTB was used as the hafnium raw material in the second embodiment, another alkoxide type organic hafnium compound, for example, another alkoxide type organic hafnium compound such as hafnium tetra normal butoxide, hafnium tetraisopropoxide may also be used. Further, although TEOS, which is an alkoxide type organic silicon compound, was used for the silicon raw material, this is not restricted but may be another silicon compound such as TDMAS, silane and disilane.

Further, in both of the embodiments, the cleaning treatment conducted before film formation is not restricted to cleaning with diluted hydrofluoric acid. Cleaning with other fluoric acid type detergent such as FNH₄ + HF may also be applied to the embodiments. Alternatively, a detergent not containing hydrofluoric acid may also be used. Further, dry cleaning using plasma may be used while such wet cleaning is not restricted. Cleaning with plasma preferably uses plasma with a high plasma density and not damaging the underlying layer, such as ICP plasma, plasma formed by radiating microwaves by using the slot antenna as described above, and remote plasma by microwaves.

Furthermore, in both of the embodiments described above, although examples of conducting the plasma oxidation treatment and the plasma nitriding treatment with plasma formed by radiating microwaves from the slot antenna were shown, the treatments may be conducted also by using other plasma with a high density such as inductive coupled plasma (ICP), remote plasma by microwaves, surface reflection wave plasma and magnetron plasma. Further, for example, oxidation treatment with ozone and nitriding treatment with ammonia may also be used without using the plasma.

Furthermore, those combining the constituent elements of the embodiments described above or those in which a part of the constituent elements of the embodiments described above is removed are also within the scope of the present invention insofar as they do not depart from the scope of the present invention.

## Claims

1. A method of forming a gate insulation film having an SiO₂ equivalent oxide thickness of 1.45 nm or less on a silicon substrate, said method comprising the steps of:
cleaning a surface of the silicon substrate to establish thereon a clean surface on which substantially no oxygen is present;
forming a hafnium silicate film on the clean surface of the silicon substrate by a CVD process using an amide type organic hafnium compound and a silicon-containing raw material;
applying an oxidation treatment to the hafnium silicate film; and
applying a nitriding treatment to the hafnium silicate film after applying the oxidation treatment.

2. The method of forming a gate insulation film according to claim 1, wherein the silicon-containing raw material is an amide type organic silicon compound.

3. The method of forming a gate insulation film according to claim 2, wherein the amide type organic hafnium compound is tetrakisdiethylaminohafnium, and the amide type organic silicon compound is tetrakisdimethylaminosilane.

4. The method of forming a gate insulation film according to any one of claims 1 to 3, wherein the oxidation treatment and the nitriding treatment are performed by using plasma.

5. The method of forming a gate insulation film according to claim 4, wherein the oxidation treatment and the nitriding treatment are performed continuously in a single plasma treatment apparatus.

6. The method of forming a gate insulation film according to claim 4 or 5, wherein the oxidation treatment and the nitriding treatment are performed by using plasma formed by radiating microwaves from a slot antenna.

7. A method of forming a gate insulation film with an SiO₂ equivalent oxide thickness of 1.45 nm or less on a silicon substrate, said method comprising the steps of:
cleaning a surface of the silicon substrate to establish thereon a clean surface on which substantially no oxygen is present;
forming a base film comprising a silicon oxide or a silicon oxynitride on the clean surface of the silicon substrate;
forming a hafnium silicate film on the base film by a CVD process using an alkoxide type organic hafnium compound and a silicon-containing raw material; and
applying a nitriding treatment to the hafnium silicate film.

8. The method of forming a gate insulation film according to claim 7, wherein the silicon-containing raw material is an alkoxide type organic silicon compound.

9. The method of forming a gate insulation film according to claim 8, wherein the alkoxide type organic hafnium compound is hafniumtetratertiarybutoxide, and the alkoxide type organic silicon compound is tetraethoxysilane.

10. The method of forming a gate insulation film according to any one of claims 7 to 9, wherein the thickness of the base film is 0.4 nm or more.

11. The method of forming a gate insulation film according to any one of claims 7 to 10, wherein the nitriding treatment is performed by using plasma.

12. The method of forming a gate insulation film according to claim 11, wherein the nitriding treatment is performed by using plasma formed by radiating microwaves from a slot antenna.

13. The method of forming a gate insulation film according to any one of claims 7 to 12, wherein an oxidation treatment is applied to the hafnium silicate film before the nitriding treatment.

14. The method of forming a gate insulation film according to claim 13, wherein the oxidation treatment is performed by using plasma.

15. The method of forming a gate insulation film according to claim 14, wherein the oxidation treatment is performed by using plasma formed by radiating microwaves from a slot antenna.

16. The method of forming a gate insulation film according to claim 14 or 15, wherein the nitriding treatment is performed by using plasma, and the oxidation treatment and nitriding treatment are performed continuously in a single plasma treatment apparatus.

17. The method of forming a gate insulation film according to any one of claims 7 to 16, wherein the step of forming the base film is performed by one or both of a treatment with ultra-violet ray excited radicals and a treatment with remote plasma.

18. The method of forming a gate insulation film according to claim 17, wherein the step of forming the base film is performed: by an oxidation treatment with UV-ray excited radicals; or by an oxidation treatment with UV-ray excited radicals and a nitriding treatment with remote plasma.

19. A method of forming a gate insulation film with an SiO₂ equivalent oxide thickness of 1.45 nm or less on a silicon substrate, said method comprising the steps of:
cleaning a surface of the silicon substrate to establish thereon a clean surface on which substantially no oxygen is present;
forming a hafnium silicate film on the clean surface of the silicon substrate by a CVD process using tetrakisdiethylaminohafnium and tetrakisdimethylaminosilane;
applying an oxidation treatment to the hafnium silicate film by using plasma formed by radiating microwaves from a slot antenna; and
applying a nitriding treatment to the hafnium silicate film, after applying the oxidation treatment, by using plasma formed by radiating microwaves from a slot antenna.

20. The method of forming a gate insulation film according to claim 19, wherein the step of forming the hafnium silicate film is performed at a film forming temperature in a range of 500 to 650°C.

21. The method of forming a gate insulation film according to claim 19, wherein the step of forming the hafnium silicate film is performed at a film forming temperature in a range of 500 to 550°C.

22. The method of forming a gate insulation film according to claim 19, wherein the step of forming the hafnium silicate film includes a first step of forming a film having a relatively high Si concentration at a relatively high temperature, and a second step of forming a film having a relatively low Si concentration at a relatively low temperature.

23. The method of forming a gate insulation film according to any one of claims 19 to 22, wherein the step of forming the hafnium silicate film is performed at a film forming pressure of 600 Pa or less.

24. The method of forming a gate insulation film according to any one of claims 19 to 23, wherein the step of forming the hafnium silicate is performed at an oxygen partial pressure of 40 Pa or less.

25. The method of forming a gate insulation film according to any one of claims 19 to 24, wherein the step of forming the hafnium silicate film is performed at a flow rate ratio of tetrakisdiethyl amino hafnium to tetrakisdimethyl amino silane of 1 or more.

26. A method of forming a gate insulation film with an SiO₂ equivalent oxide thickness of 1.45 nm or less on a silicon substrate, said method comprising the steps of:
cleaning a surface of the silicon substrate to establish thereon a clean surface on which substantially no oxygen is present;
forming a base film comprising silicon oxide or silicon oxynitride on the clean surface of the silicon substrate;
forming a hafnium silicate film on the base film by a CVD process using hafniumtetratertiarybutoxide and tetraethoxysilane;
applying an oxidation treatment to the hafnium silicate film by using plasma formed by radiating microwaves from a slot antenna; and
applying a nitriding treatment to the hafnium silicate film, after applying the oxidation treatment, by using plasma formed by radiating microwaves from a slot antenna.

27. The method of forming a gate insulation film according to claim 26, wherein the step of forming the base film is performed by one or both of a treatment with UV-ray excited radicals and a treatment with remote plasma.

28. The method of forming a gate insulation film according to claim 27, wherein the step of forming the base film is performed: by an oxidation treatment with UV-ray excited radicals; or an oxidation treatment with UV-ray excited radicals and a nitriding treatment with remote plasma.

29. The method of forming a gate insulation film according to any one of claims 1 to 28, wherein the step of cleaning the surface of the silicon substrate is performed by using a hydrofluoric acid series detergent.

30. The method of forming a gate insulation film according to any one of claims 1 to 29, wherein the SiO₂ equivalent oxide thickness of the gate insulation film is 1.4 nm or less.

31. The method of forming a gate insulation film according to any one of claims 1 to 29, wherein the SiO₂ equivalent oxide thickness of the gate insulation film is 1.2 nm or less.

32. A computer-readable storage medium that stores software for causing a computer to execute a control program, wherein the control program, upon execution, causes a processing system to perform the steps of:
forming a hafnium silicate film on a surface of a silicon substrate, which has been cleaned so as to establish thereon a clean surface on which substantially no oxygen is present, by a CVD process using an amide type organic hafnium compound and a silicon-containing raw material;
applying an oxidation treatment to the hafnium silicate film; and
applying a nitriding treatment to the hafnium silicate film after applying the oxidation treatment,
whereby a gate insulation film with a SiO₂ equivalent oxide thickness of 1.45 nm or less is formed on the substrate on the silicon su bstrate.

33. A computer program including software that operates on a computer, wherein the software, upon execution, causes a processing system to perform the steps of:
forming a hafnium silicate film on a surface of a silicon substrate, which has been cleaned so as to establish thereon a clean surface on which substantially no oxygen is present, by a CVD process using an amide type organic hafnium compound and a silicon-containing raw material;
applying an oxidation treatment to the hafnium silicate film;
applying a nitriding treatment to the hafnium silicate film after applying the oxidation treatment,
whereby a gate insulation film with a SiO₂ equivalent oxide thickness of 1.45 nm or less is formed on the substrate on the silicon substrate.

34. A computer-readable storage medium that stores software for causing a computer to execute a control program, wherein the control program, upon execution, causes a processing system to perform the steps of:
forming a base film comprising a silicon oxide or silicon oxynitride on a surface of a silicon substrate, which has been cleaned so as to establish a clean surface on which substantially no oxygen is present;
forming a hafnium silicate film on the base film by a CVD process using an alkoxide type organic hafnium compound and a silicon-containing raw material; and
applying a nitriding treatment to the hafnium silicate film,
whereby a gate insulation film with a SiO₂ equivalent oxide thickness of 1.45 nm or less is formed on the silicon substrate.

35. A computer program comprising software that operates on a computer, wherein the software, upon execution, causes a processing system to perform the steps of:
forming a base film comprising silicon oxide or silicon oxynitride on a surface of a silicon substrate, which has been cleaned so as to establish thereon a clean surface on which substantially no oxygen is present,
forming a hafnium silicate film on the base film by a CVD process using an alkoxide type organic hafnium compound and a silicon-containing raw material; and
applying a nitriding treatment to the hafnium silicate film,
whereby a gate insulation film with a SiO₂ equivalent oxide thickness of 1.45 nm or less is formed on the silicon substrate.
